# EUROPÄISCHE PATENTANMELDUNG

(11) **EP 3 674 439 A1**
(43) Veröffentlichungstag der Anmeldung: **01.07.2020**
(21) Anmeldenummer: 19217465.4
(22) Anmeldetag: 18.12.2019
(51) Int. Cl.: C23C 16/54

(54) **VORRICHTUNG UND VERFAHREN ZUM BESCHICHTEN VON BEHÄLTNISSEN**

(30) Priorität: 18.12.2018 DE 102018132609
(71) Anmelder: Krones AG, 93073 Neutraubling (DE)
(72) Erfinder: Krüger, Jochen, 93073 Neutraubling (DE); Neubauer, Michael, 93073 Neutraubling (DE)
(74) Vertreter: Bittner, Bernhard

(57) **Zusammenfassung**

Vorrichtung (1) zum Beschichten von Behältnissen (10) mit wenigstens einer Vakuumvorrichtung zur Erzeugung eines Vakuums, mit wenigstens einer Behandlungsstation (8) zum Beschichten von Behältnissen (10) mit einem Plasma, wobei die Behandlungsstation (8) in einer Fluidverbindung mit der Vakuumvorrichtung steht und wobei die Behandlungsstation (8) wenigstens eine Behandlungseinrichtung (800) aufweist, die in ein Behältnis (10) einführbar ist, mit einer Fördereinrichtung zum Transportieren von Behältnissen (10) auf einem Transportpfad P und mit wenigstens einem Trägerelement (402) zur Aufnahme von mindestens einem Behältnis (10), wobei das Trägerelement (402) in einer Richtung senkrecht zum Transportpfad P der Behältnisse beweglich ist und dazu geeignet ist, das Behältnis (10) in eine Behandlungsstation (8) einzuführen, wobei an dem Trägerelement (402) ein Verschlusselement (404) angeordnet ist und das Verschlusselement (404) dazu geeignet ist, die Behandlungsstation (8) luftdicht zu verschließen.

## Beschreibung

Die vorliegende Erfindung betrifft eine Vorrichtung und ein Verfahren zum Behandeln von Behältnissen. Derartige Behandlungsmaschinen für Behältnisse sind im Stand der Technik überwiegend als Rundläufermaschinen aufgebaut. Dieser Aufbau hat einige Vorteile. So sind z. B. bei Rundläufermaschinen hohe Maschinenleistungen möglich.

Rundläufermaschinen haben jedoch auch einige Nachteile. So weisen sie zum einen große bewegte Massen auf. Nachteilig ist zum anderen, dass sich die Behandlungsstationen auf dem drehenden Teil der Rundläufermaschinen befinden. Sowohl die Behandlungsstationen selbst als auch die Prozessmedien (z. B. Füllmedium bei Füllmaschinen, Tinte bei Druckmaschinen, etc.) sind daher hohen Fliehkräften ausgesetzt. Außerdem ist hierbei eine aufwendige Drehdurchführung für die Leistungs- und Medienversorgung erforderlich. Zusätzlich sind Rundläufermaschinen relativ unflexibel. Eine Erweiterung der Anlage ist nur schwer möglich. Auch muss die gesamte Anlage stillstehen, wenn lediglich eine einzelne Behandlungsstation gewartet werden soll.

Der Erfindung liegt daher die Aufgabe zugrunde, eine Vorrichtung und ein Verfahren zur Verfügung zu stellen, das diese genannten Nachteile nicht aufweist.

Diese Aufgaben werden erfindungsgemäß durch die Gegenstände der unabhängigen Patentansprüche erreicht. Vorteilhafte Ausführungsformen und Weiterbildungen sind Gegenstand der Unteransprüche.

Eine erfindungsgemäße Vorrichtung zum Behandeln von Behältnissen weist wenigstens eine Transporteinrichtung zum Transportieren der Behältnisse auf. Die erfindungsgemäße Vorrichtung weist eine Handhabungsvorrichtung zur Übergabe einer vordefinierten Anzahl von Behältnissen von der Transporteinrichtung in einem Übergabebereich und zur Abgabe dieser Behältnisse an die Transporteinrichtung oder eine weitere Transporteinrichtung in einem Abgabebereich auf. Die erfindungsgemäße Vorrichtung weist außerdem wenigstens eine weitere Handhabungsvorrichtung zur Übergabe einer vordefinierten Anzahl von Behältnissen von der Transporteinrichtung in einem weiteren Übergabebereich und zur Abgabe dieser Behältnisse an die Transporteinrichtung oder eine weitere Transporteinrichtung in einem weiteren Abgabebereich auf. Die Handhabungsvorrichtungen weisen dabei jeweils einen beweglichen Träger auf, mit dem die entnommenen Behältnisse auf einem Transportpfad bewegt werden können. Den Handhabungsvorrichtungen ist weiter jeweils wenigstens eine Behandlungsstation zugeordnet.

Erfindungsgemäß ist die Transportgeschwindigkeit der Handhabungsvorrichtungen derart steuerbar, dass die Transportgeschwindigkeit der Handhabungsvorrichtungen bei der Übergabe und/oder Abgabe der Behältnisse mit der Transportgeschwindigkeit der Transporteinrichtung und/oder der weiteren Transporteinrichtung synchronisierbar ist. Erfindungsgemäß ist die Transportgeschwindigkeit der Handhabungsvorrichtung nach der Übergabe der Behältnisse reduzierbar.

Unter dem Begriff der "Transportgeschwindigkeit" ist dabei die Geschwindigkeit zu verstehen, mit der Behältnisse entlang eines Transportpfads bewegt werden.

Bei einer vorteilhaften Ausführungsform ist die Transportgeschwindigkeit auf Null reduzierbar. Bevorzugt ist die Geschwindigkeit der Behältnisse im Bereich der Behandlungsstationen bis zum Stillstand der Behältnisse reduzierbar.

Vorteilhaft handelt es sich bei dem beweglichen Träger um einen drehbaren Träger. Es kann sich jedoch auch beispielsweise um einen schwenkbaren Träger handeln. Vorteilhaft weisen alle Handhabungsvorrichtungen die gleiche Umlaufrichtung auf. Bevorzugt weist eine Handhabungsvorrichtung mindestens eine Handhabungseinheit zur Aufnahme eines Behältnisses auf. Besonders bevorzugt weist eine Handhabungsvorrichtung mehrere Handhabungseinheiten auf, von denen jede zur Aufnahme eines Behältnisses geeignet ist. Bei den Handhabungseinheiten kann es sich bevorzugt um Haltevorrichtungen o. ä. handeln, die die Behältnisse aufnehmen. Bevorzugt handelt es sich um Greifer, wie beispielsweise Neckhandlingklammern, die die Behältnisse greifen.

Es sind jedoch auch andere Gestaltungen der Handhabungsvorrichtungen denkbar. Die Handhabungsvorrichtungen könnten z. B. statt dem Dreh-(Hub-)Mechanismus auch über ein Portalsystem, einen Tripod-Roboter oder einen Roboter-Arm verfügen, um sich zur Behältnisaufnahme und -abgabe auf die kontinuierlich laufende Transporteinrichtung aufzusynchronisieren und die Behältnisse anschließend zu den Behandlungsstationen zu bringen.

Bei einer vorteilhaften Ausführungsform werden die Behältnisse von der Transporteinrichtung entlang einer Zulaufstrecke transportiert. Bevorzugt liegen entlang dieser Zulaufstrecke die Übergabebereiche zu den Handhabungsvorrichtungen. Vorteilhaft ist jeder Handhabungsvorrichtung ein eigener Übergabebereich zugeordnet. Bevorzugt ist die Anzahl der Übergabebereiche mit der Anzahl der Handhabungsvorrichtungen identisch. Vorteilhaft weist die Vorrichtung eine Vielzahl von Handhabungsvorrichtungen auf. Bevorzugt befinden sich entlang der Zulaufstrecke der Transporteinrichtung mehrere Übergabebereiche.

Bei einer bevorzugten Ausführungsform werden somit ein oder mehrere Behältnisse an eine Handhabungsvorrichtung übergeben, während die anderen Behältnisse von der Transporteinrichtung weitertransportiert werden. Vorteilhaft werden die weitertransportierten Behältnisse an eine weitere Handhabungsvorrichtung übergeben.

Vorteilhaft handelt es sich bei dem Übergabebereich um einen exakt definierten räumlichen Bereich. Dies bedeutet insbesondere, dass jedes Behältnis, das an eine bestimmte Handhabungsvorrichtung übergeben wird, innerhalb dieses Übergabebereichs übergeben wird. Vorteilhaft ist der Übergabebereich kleiner als 10 cm, bevorzugt kleiner als 5 cm und besonders bevorzugt kleiner als 1 cm.

Bei einer vorteilhaften Ausführungsform entnimmt jede Handhabungsvorrichtung in ihrem Übergabebereich einen oder mehrere Behältnisse aus dem Zulauf. Vorzugsweise entnimmt die Handhabungsvorrichtung die Behältnisse mit einer Rotationsbewegung. Werden der Handhabungsvorrichtung mehrere Behältnisse übergeben, werden diese Behältnisse bevorzugt nacheinander im Übergabebereich, also im Wesentlichen am selben Übergabepunkt, übergeben. Alternativ werden die Behältnisse mit einer Entnahmevorrichtung, beispielsweise einem Roboter, aus dem Zulauf entnommen und an die Behandlungsstationen übergeben.

Bei dieser Ausführungsform, erfolgt eine Übergabe der Behältnisse nicht am selben Übergabepunkt.

Vorteilhaft handelt es sich bei dem Abgabebereich um einen exakt definierten räumlichen Bereich. Dies bedeutet insbesondere, dass jedes Behältnis, das von einer bestimmten Handhabungsvorrichtung abgegeben wird, innerhalb dieses Abgabebereichs abgegeben wird. Vorteilhaft ist der Abgabebereich kleiner als 10 cm, bevorzugt kleiner als 5 cm und besonders bevorzugt kleiner als 1 cm.

Bei einer vorteilhaften Ausführungsform gibt jede Handhabungsvorrichtung in ihrem Abgabebereich ein oder mehrere Behältnisse an den Auslauf ab. Vorzugsweise gibt die Handhabungsvorrichtung die Behältnisse mit einer Rotationsbewegung ab. Gibt die Handhabungsvorrichtung mehrere Behältnisse ab, werden diese Behältnisse bevorzugt nacheinander im Abgabebereich, also im Wesentlichen am selben Abgabepunkt, abgegeben. Alternativ werden die Behältnisse mit einer Abgabevorrichtung, beispielsweise einem Roboter, aus den Behandlungsstationen entnommen und an den Auslauf übergeben. Bei dieser Ausführungsform, erfolgt eine Übergabe der Behältnisse nicht am selben Übergabepunkt.

Bevorzugt sind jeder Handhabungsvorrichtung mehrere Behandlungsstationen zugewiesen. Vorteilhaft weist jede Handhabungsvorrichtung mindestens die Anzahl an Behandlungsstationen auf, die der vordefinierten Anzahl von Behältnissen entspricht, die der Handhabungsvorrichtung in einem Zyklus am Übergabepunkt übergeben werden. Bevorzugt weist die Handhabungsvorrichtung exakt diese Anzahl an Behandlungsstationen auf. Werden der Handhabungsvorrichtung in einem Zyklus beispielsweise vier Behältnisse übergeben, weist diese Handhabungsvorrichtung bevorzugt auch mindestens vier Behandlungsstationen auf.

Bei einer bevorzugten Ausführungsform sind die Behandlungsstationen stationär angeordnet.

Vorteilhaft ist eine Behandlungsstation dazu geeignet, mindestens ein Behältnis zu behandeln. Bei den Behandlungsstationen kann es sich beispielsweise um Stationen für einen Füll- und/oder Verschließvorgang, einen Streckblasvorgang, einen Dekorationsvorgang oder einen Beschichtungsvorgang handeln. Der Vorteil bei einer stationären Anordnung von Behandlungsstationen für einen Streckblasvorgang liegt darin, dass die schwere Blasstation mit ihren vielen Medienversorgungen nicht mehr auf einem rotierenden Blasrad sitzen muss, sondern einfach stationär in der Maschine platziert sein kann. Dies bringt einen erheblichen Kostenvorteil. Bei Behandlungsstationen für einen Dekorationsvorgang kann es sich z. B. um Stationen für eine Etikettierung und/oder Bedruckung handeln. Bei einer Behandlungsstation für einen Beschichtungsvorgang kann es sich um Stationen für die Beschichtung der Innen- und/oder Außenseite des Behälters handeln. Insbesondere kann es sich dabei um Stationen für Plasmabeschichtung handeln. Vorteilhaft weist jede Behandlungsstation eine Vakuumkammer auf. Bevorzugt weist die Vorrichtung auch wenigstens eine Vakuumpumpe auf.

Bei einer bevorzugten Ausführungsform ist die Behandlungsstation bezogen auf den Transportpfad der Behältnisse stromabwärts des Übergabebereichs und/oder stromaufwärts des Abgabebereichs angeordnet. Diese Anordnung gilt bevorzugt für jede der Behandlungsstationen. Dies bedeutet, dass zuerst Behältnisse in einem Übergabebereich an eine Handhabungsvorrichtung übergeben werden, einer stromabwärts angeordneten Behandlungsstation zugeführt werden und nach einer Behandlung in einem Abgabebereich von der Handhabungsvorrichtung abgegeben werden.

Bei einer vorteilhaften Ausführungsform sind der Übergabebereich und der Abgabebereich einer Handhabungsvorrichtung räumlich voneinander getrennt angeordnet. Bevorzugt ist der Abgabebereich nach einer 180°-Drehung der Handhabungsvorrichtung ausgehend vom Übergabebereich angeordnet.

Bei einer Umlaufrichtung im Uhrzeigersinn kann ein beispielhafter Zyklus der Handhabungsvorrichtung folgendermaßen aussehen: Die Handhabungsvorrichtung rotiert bei "12 Uhr" synchron zur Transporteinrichtung und entnimmt einen oder mehrere Behältnisse. Nach Verlassen des Kollisionsbereiches mit den nachfolgenden Behältnissen verzögert die Handhabungsvorrichtung ihre Rotation bis sie auf der "3 Uhr"-Position zum Stillstand kommt. Nun erfolgt die Behandlung. Anschließend beschleunigt die Handhabungsvorrichtung um in der "6 Uhr"-Position synchron mit dem Auslaufteil der Transporteinrichtung zu sein und den oder die Behältnisse abgeben zu können. Die Rotation der Handhabungsvorrichtung wird nun ohne Behältnisse bis zur "12 Uhr"-Position fortgesetzt. Hier kann ein neuer Zyklus starten.

Bevorzugt können die Handhabungsvorrichtungen bei dieser Ausführungsform entlang eines Transferovals angeordnet sein, also an einer Transporteinrichtung, bei der die Behältnisse entlang eines ovalen Transportpfads bewegt werden. Hierbei können die Handhabungsvorrichtungen beispielsweise bevorzugt innerhalb des Transferovals angeordnet sein, also auf der dem Krümmungsmittelpunkt zugewandten Seite der Transporteinrichtung.

In diesem Fall können den Handhabungsvorrichtungen vorteilhaft im ersten linearen Bereich des Transferovals die Behältnisse übergeben werden. Die Behältnisse werden dann von den Handhabungsvorrichtungen zu Behandlungsstationen transportiert, die sich innerhalb des Transferovals befinden. Nach der Behandlung werden die Behältnisse von der Handhabungsvorrichtung weitertransportiert und in dem zweiten, dem ersten gegenüberliegenden, linearen Bereich des Transferovals die Behältnisse an die Transporteinrichtung wieder abgeben. Bei dieser Ausführungsform ist nur eine einzelne Transporteinrichtung erforderlich, weil die Behältnisse von der gleichen Transporteinrichtung übergeben und nach der Behandlung an diese wieder abgegeben werden.

Alternativ dazu können jedoch auch zwei Transporteinrichtungen zum Einsatz kommen. Beispielsweise können die Handhabungsvorrichtungen in diesem Fall zwischen zwei linearen Bereichen von zwei verschiedenen Transferovalen angeordnet sein. In diesem Fall können die Handhabungsvorrichtungen Behältnisse aus der einen Transporteinrichtung übernehmen, die Behältnisse zu Behandlungsstationen zwischen den Transporteinrichtungen transportieren und nach der Behandlung die Behältnisse an die zweite Transporteinrichtung abgeben. Vorteilhaft sind bei einer solchen Ausführungsform die linearen Abschnitte der beiden Transporteinrichtungen, von denen die Behältnisse übergeben, bzw. an die die Behältnisse abgegeben werden, parallel zueinander angeordnet.

Bei einer hierzu alternativen, bevorzugten Ausführungsform sind der Übergabebereich und der Abgabebereich einer Handhabungsvorrichtung nicht räumlich voneinander getrennt angeordnet, sondern es stimmt der Abgabebereich einer Handhabungsvorrichtung mit dem Übergabebereich einer Handhabungsvorrichtung räumlich überein. Vorteilhaft ist die Handhabungsvorrichtung somit dafür geeignet, im gleichen Bereich Behältnisse aufzunehmen bzw. abzugeben. Besonders bevorzugt ist die Handhabungsvorrichtung dazu geeignet, abwechselnd Behältnisse aufzunehmen und abzugeben.

Während bei der zuvor beschriebenen Ausführungsform die Handhabungsvorrichtung zwei Kontaktpunkte (Übergabe- bzw. Abgabebereich) mit der Transporteinrichtung hat, ist bei dieser Ausführungsform nur ein Kontaktpunkt erforderlich. Bei der zuerst beschriebenen Ausführungsform ist mehr mechanische Einstellarbeit erforderlich, da ein Einstellen eines Punktes zu einer Verstellung des anderen Punktes führt. In der alternativ beschriebenen Ausführungsform gibt es nur einen Kontaktpunkt, was das Montieren und Justieren der Maschine deutlich vereinfacht.

Vorteilhaft wird bei dieser Ausführungsform statt einem separaten Ein- und Auslaufstern nur noch ein Stern oder eine andere geeignete Transporteinrichtung wie zum Beispiel eine Transferkette benötigt, über den die Behältnisse der Transporteinrichtung zugeführt und von dieser abgeführt werden können.

Bei einer bevorzugten Ausführungsform ist die Transporteinrichtung derart gestaltet, dass sie die Kunststoffvorformlinge in einer vorgegebenen und insbesondere auch einheitlichen Ausrichtung bezogen auf deren Längsachse transportiert. Vorteilhaft weist die Transporteinrichtung eine Vielzahl von Transporteinheiten zum Transportieren von je einem Behältnis auf. Vorteilhaft kann es sich bei den Transporteinheiten um Haltevorrichtungen o. ä. handeln, die die zu transportierenden Behältnisse aufnehmen. Bevorzugt handelt es sich um Greifer, wie beispielsweise Neckhandlingklammern, die die Behältnisse greifen.

Bei einer vorteilhaften Ausführungsform ist die Transporteinrichtung und/oder eine weitere Transporteinrichtung eine lineare Transporteinrichtung. Unter dem Begriff der linearen Transporteinrichtung ist zu verstehen, dass der Transport zumindest abschnittsweise linear erfolgt. Dabei ist nicht ausgeschlossen, dass der Transport abschnittsweise auch auf einer gekrümmten Bahn erfolgt. Die Transporteinrichtung kann beispielsweise als Transferoval ausgebildet sein. Es ist auch ein rein linearer Transfer denkbar. Alternativ wäre es auch denkbar, die Transporteinrichtung als Transportkarussell zu gestalten. Auch eine Transporteinrichtung in Form von Sternsäulen ist denkbar.

Beispielsweise kann eine lineare Transporteinrichtung, insbesondere ein Transportband, eine Transportkette oder ein Individualtransport mittels Linearmotor, verwendet werden. Bei der Transporteinrichtung kann es sich somit z. B. um ein ketten- oder riemenbasiertes System handeln. Alternativ wäre auch der Einsatz eines Langstator-Linearmotorsystems denkbar.

Bei einer bevorzugten Ausführungsform sind die Handhabungsvorrichtungen seitlich an der Transporteinrichtung angeordnet. Vorteilhaft sind die Handhabungsvorrichtungen zu der Transporteinrichtung so positioniert, dass sie in geeigneter Weise die zu behandelnden Objekte von der Transporteinrichtung entnehmen bzw. nach erfolgter Behandlung die Objekte an die Transporteinrichtung abgeben können.

Im Falle einer zumindest abschnittsweise gekrümmten Transportbahn sind die Handhabungsvorrichtungen bevorzugt auf der dem Krümmungsmittelpunkt abgewandten Seite der Transporteinrichtung angeordnet. Im Falle eines Transportkarussells sind die Handhabungsvorrichtungen bevorzugt außerhalb des Transportkarussells - wie Satelliten - angeordnet. Auch im Falle eines Transportovals sind die Handhabungsvorrichtungen bevorzugt an der "Außenseite" außerhalb des vom Transportoval eingeschlossenen Bereichs angeordnet.

Vorteilhaft sind auch die Behandlungsstationen auf der dem Krümmungsmittelpunkt abgewandten Seite der Transporteinrichtung angeordnet. Auf diese Weise kann vorteilhaft eine bessere Zugänglichkeit der Handhabungsvorrichtungen und der Behandlungsstationen sichergestellt werden, da diese nicht innerhalb des Transportkarussells/Transportovals liegen, sondern außerhalb.

Besonders bevorzugt wird diese Anordnung der Handhabungsvorrichtungen bei der bevorzugten Ausführungsform gewählt, bei der der Abgabebereich der Handhabungsvorrichtung mit dem Übergabebereich der Handhabungsvorrichtung räumlich übereinstimmt.

Bei einer vorteilhaften Ausführungsform sind die Drehachsen der Handhabungsvorrichtungen derart angeordnet, dass die Drehachse der einen Handhabungsvorrichtung im Schwenckreis der Drehachse einer weiteren Handhabungsvorrichtung angeordnet ist.

Vorteilhaft sind die Handhabungsvorrichtungen im Wesentlichen äquidistant angeordnet. Der Begriff "im Wesentlichen" bezieht sich zum einen darauf, dass der Abstand zwischen den einzelnen Handhabungsvorrichtungen um nicht mehr als 30 %, bevorzugt um nicht mehr als 20 % und besonders bevorzugt um nicht mehr als 10 % voneinander abweicht.

Zum anderen bezieht sich der Begriff "im Wesentlichen" jedoch auch darauf, dass nicht ausgeschlossen werden soll, dass der Abstand zwischen einzelnen Handhabungsvorrichtungen hiervon merklich abweichen können. So soll unter den Begriff "im Wesentlichen äquidistant" beispielsweise auch eine Anordnung mit einem Transportoval fallen, bei dem zwar die Abstände jeweils zwischen den Handhabungsvorrichtungen im Bereich des einen bzw. des anderen linearen Abschnitts gleich sind, im Krümmungsbereich der Transporteinrichtung jedoch andere Abstände vorliegen, bzw. auch, dass in diesem Transportbereich überhaupt keine Handhabungsvorrichtung angeordnet sind. Demnach soll auch ein Ausführungsbeispiel unter den Begriff "im Wesentlichen äquidistant" fallen, bei dem die Handhabungsvorrichtungen a bis e in einem linearen Abschnitt eines Transportovals angeordnet sind, nach der Handhabungsvorrichtung e ein gekrümmter Transportabschnitt des Transportovals ohne Handhabungsvorrichtungen folgt und die Handhabungsvorrichtungen f bis j in einem weiteren linearen Abschnitt angeordnet sind.

Bei einer weiteren bevorzugten Ausführungsform weist die Vorrichtung mindestens eine zusätzliche Handhabungsvorrichtung und/oder Behandlungsstation auf, die für das Erreichen einer gewünschten Maschinenleistung nicht erforderlich wäre.

Vorteilhaft weist die Vorrichtung eine zusätzliche Handhabungsvorrichtung und/oder Behandlungsstation auf, die in einem Normalbetrieb nicht genutzt wird. D. h. bei einer möglichen Ausführungsform werden zusätzlich zu den zur Erreichung der Maschinenleistung erforderlichen Stationen eine oder mehrere Ersatz- bzw. Reservestationen vorgesehen. Bevorzugt beinhaltet diese Ersatz- bzw. Reservestation eine Handhabungsvorrichtung und wenigstens eine Behandlungsstation.

Vorteilhaft ist diese Reservestation im Normalbetrieb nicht aktiviert. Bevorzugt wird die Reservestation erst bei Ausfall/Defekt oder der Notwendigkeit der Wartung einer Station aktiviert, während die betreffende Station deaktiviert wird. Der Vorteil besteht darin, dass der Produktionsbetrieb somit mit 100 % Leistung aufrechterhalten werden kann, da die Anzahl der produzierenden Stationen gleichbleibt. Außerdem kann die stillstehende Station vorteilhaft gewartet werden, während die restlichen Stationen weiter produzieren, was eine erhebliche Steigerung der Maschinenperformance im Vergleich zum kompletten Stillstand der Maschine (wie es z. B. bei Karussellmaschinen erforderlich wäre) bedeutet.

Um einen gleichmäßigen Verschleiß über alle Stationen zu erhalten, kann die Reservestation bevorzugt auch dynamisch verschoben werden. Beispielsweise pausiert Station a eine Stunde, in der nächsten Stunde pausiert Station b, usw.). Somit haben alle Stationen über einen längeren Zeitraum gesehen annähernd die gleiche Laufzeit.

Bei einer alternativen Ausführungsform bekommt die Vorrichtung ebenfalls eine oder mehrere Stationen mehr, als eigentlich zur Erreichung der gewünschten Maschinenleistung erforderlich wären. D. h. auch bei dieser Ausführungsform wird die Vorrichtung in gewissem Maße überdimensioniert. Beispielsweise kann bei einer Ausführungsform, bei der jede Station 2000 Behälter pro Stunde (bph) verarbeiten kann und die gewünschte Maschinenleistung bei 40000 bph liegt, die Maschine nicht mit 20 Stationen ausgestattet werden, sondern mit 21. Im Normalbetrieb laufen dann alle 21 Stationen mit einer reduzierten Leistung von ca. 1905 bph. Bei Ausfall einer Station wird die Leistung der verbleibenden 20 Stationen auf 2000 bph erhöht. Somit kann die Maschinenleistung weiterhin bei 40000 bph liegen.

Bei den Behältnissen kann es sich insbesondere um Getränkebehältnisse, Kunststoffbehältnisse, Vorformlinge, Glasbehältnisse, Dosen und dergleichen handeln.

Bei einer vorteilhaften Ausführungsform wird eine Bewegung der Behältnisse in einer Richtung senkrecht zum Transportpfad P der Behältnisse mithilfe von Trägerelementen durchgeführt. Bevorzugt kann es sich dabei um eine Bewegung senkrecht nach unten oder senkrecht nach oben durchgeführt. Die Begriffe "unten" und "oben" sind dabei bevorzugt in Richtung der Schwerkraft zu verstehen. Vorteilhaft stimmt diese Richtung mit einer Längsrichtung der transportierten Behältnisse überein. Davon ist bevorzugt auch umfasst, dass die Behältnisse mit einer Öffnung nach unten (bezogen auf die Schwerkraft) transportiert werden. Bei einer solchen Ausrichtung würde eine Bewegung nach unten (bezogen auf die Schwerkraft) demnach eine Bewegung in Richtung der Öffnung der Behältnisse bedeuten, also in die Richtung, die bezogen auf die Behältnisgeometrie üblicherweise als "oben" bezeichnet wird.

Bei einer bevorzugten Ausführungsform ist an dem Trägerelement ein Verschlusselement angeordnet. Vorteilhaft ist dieses Verschlusselement dazu geeignet, die Behandlungsstation luftdicht zu verschließen. Insbesondere ist das Verschlusselement bevorzugt dazu geeignet, eine Vakuumkammer der Behandlungsstation luftdicht zu verschließen.

Es wird darauf hingewiesen, dass diese Ausgestaltung auch unabhängig von der oben beschriebenen Ausführungsform Anwendung finden kann. Die Anmelderin behält sich daher vor, Schutz zu beanspruchen für eine Vorrichtung zum Beschichten von Behältnissen mit wenigstens einer Vakuumvorrichtung zur Erzeugung eines Vakuums, mit wenigstens einer Behandlungsstation zum Beschichten von Behältnissen mit einem Plasma, wobei die Behandlungsstation in einer Fluidverbindung mit der Vakuumvorrichtung steht und wobei die Behandlungsstation wenigstens eine Behandlungseinrichtung aufweist, die in ein Behältnis einführbar ist, mit einer Fördereinrichtung zum Transportieren von Behältnissen auf einem Transportpfad P und mit wenigstens einem Trägerelement zur Aufnahme von mindestens einem Behältnis.

Erfindungsgemäß ist das Trägerelement in einer von Null verschiedenen Richtung zum Transportpfad P der Behältnisse beweglich und dazu geeignet, das Behältnis in die Behandlungsstation einzuführen, wobei an dem Trägerelement ein Verschlusselement angeordnet ist und das Verschlusselement dazu geeignet ist, die Behandlungsstation im Wesentlichen luftdicht zu verschließen.

Unter dem Begriff "im Wesentlichen luftdicht" ist dabei zu verstehen, dass nur ein geringer Gasaustausch stattfinden kann. Der Gasaustausch soll dabei bevorzugt so gering sein, dass dieser bei einem Evakuieren der Behandlungsstation vernachlässigbar klein ist.

Die Begriffe "einführbar" bzw. "einführen" sind dabei immer als Relativbewegung der jeweiligen Elemente zu verstehen. Es ist dabei sowohl umfasst, dass sich die Elemente (z. B. die Behandlungseinrichtung und ein Behältnis) beide aufeinander zubewegen, allerdings auch, dass eines der Elemente ruht, während sich nur das andere bewegt. Hinsichtlich der Bewegung nur eines Elements sind insbesondere beide Varianten umfasst, also sowohl die Bewegung des 1. Elements (z. B. der Behandlungseinrichtung) als auch die des 2. Elements (z. B. des Behältnisses), während das jeweils andere Element ruht.

Das Trägerelement ist zur Aufnahme von mindestens einem Behältnis geeignet und umfasst dafür ausgebildete Vorrichtungen (im Folgenden auch Aufnahmen genannt), beispielsweise Klammern oder andere Behältnisaufnahmevorrichtungen. Typischerweise sind diese Behältnisaufnahmevorrichtungen oder Klammern so angeordnet, dass eine Behältnisbehandlung in der Behandlungsstation mit ihnen erfolgen kann, sie also die Behältnisbehandlung nicht behindern. Die Klammern können insbesondere passiv sein, d.h. ohne äußeren Einfluss in ihrem jeweiligen Zustand, d.h. geöffnet oder geschlossen, verbleiben, so dass nur zum Umschalten zwischen geöffneten und geschlossenen Zustand geschaltet werden muss. Insbesondere können solche passive Klammern dann die Behältnisse von selber halten. Es können in anderen Ausführungsformen auch aktiv gesteuerte Klammern verwendet werden, die aktiv geschlossen gehalten werden müssen und ohne Einwirkung geöffnet sind, oder umgekehrt, also Klammern die aktiv geöffnet gehalten werden müssen und ohne Einwirkung geschlossen sind. Die Aufnahmen können optional höhenverstellbar sein, sodass sie für Behältnisse verschiedener Größen verwendet werden können.

Bei einer bevorzugten Ausführungsform ist die Fördereinrichtung dazu geeignet, die Behältnisse entlang eines umlaufenden Transportpfades zu bewegen. Vorteilhaft werden die Behältnisse von der Fördereinrichtung auf einem zumindest abschnittsweise gekrümmten Transportpfad bewegt. Bevorzugt weist die Fördereinrichtung einen drehbaren Träger auf.

Vorteilhaft umfasst die Fördereinrichtung ein drehbares Karussell mit entlang eines Teilkreises in gleichmäßigen Abständen zueinander angeordneten Halterungen für die Behältnisse. Bevorzugt ist die Fördereinrichtung eine Rundläufermaschine.

Bevorzugt kann es sich bei der Fördereinrichtung um die beschriebene Handhabungsvorrichtung handeln. Die hier beschriebene Vorrichtung zum Beschichten von Behältnissen wird daher besonders bevorzugt mit der oben beschriebenen Vorrichtung zum Behandeln von Behältnissen mit wenigstens zwei Handhabungsvorrichtungen verwendet.

Vorteilhaft können einer Fördereinrichtung bzw. Handhabungsvorrichtung mehr als eine Behandlungsstation zugeordnet sein.

Bei einer bevorzugten Ausführungsform ist die Behandlungsstation unter oder über des Transportpfads P der Behältnisse angeordnet. Dabei ist es auch möglich, dass die Behandlungsstationen nicht unmittelbar unter oder über dem Transportpfad, sondern seitlich versetzt dazu angeordnet sind. So wäre es beispielsweise möglich, dass bei einem zumindest abschnittsweise kreisförmigen Transportpfad die Behandlungsstationen radial nach außen oder auch nach innen versetzt sind. Beispielsweise könnten sich die Behandlungsstationen unterhalb des Transportpfads radial nach außen versetzt befinden.

Bevorzugt ist das Trägerelement in einer Richtung senkrecht zum Transportpfad P der Behältnisse beweglich. Bevorzugt erfolgt die Bewegung des Trägerelements zum Einführen des Behältnisses in die Behandlungsstation nach unten oder oben. Besonders bevorzugt sind die Behandlungsstationen unter dem Transportpfad der Behältnisse angeordnet und die Bewegung des Trägerelements zum Einführen des Behältnisses in die Behandlungsstation erfolgt nach unten. Vorteilhaft ist das Trägerelement dazu ausgebildet, die Behältnisse mit ihrer Öffnung nach unten zu transportieren. Bevorzugt erfolgt die Bewegung des Trägerelements zum Einführen des Behältnisses in die Behandlungsstation in Längsrichtung des Behältnisses. Besonders bevorzugt erfolgt die Bewegung bezogen auf die Schwerkraft nach unten, bezogen auf die Behältnisgeometrie jedoch nach oben, also in Richtung der Öffnung des Behältnisses.

Dabei ist es auch möglich, dass sowohl eine Bewegung nach unten bzw. oben erfolgt als auch eine Bewegung in seitlicher Richtung zum Transportpfad. Dies ist beispielsweise erforderlich, wenn sich die Behandlungsstationen unterhalb des Transportpfads radial nach außen versetzt befinden. Vorteilhaft weist die Vorrichtung hierzu eine Hub-Dreh-Vorrichtung auf. Diese Hub-Dreh-Vorrichtung ist vorteilhaft dazu geeignet, Behältnisse von der Fördereinrichtung zu entnehmen. Bevorzugt entnimmt die Hub-Dreh-Vorrichtung ein Behältnis von der Fördereinrichtung und schwenkt es über bzw. unter die Behandlungsstation. Vorteilhaft wird das Behältnis von der Hub-Dreh-Vorrichtung in die Behandlungsstation abgesenkt bzw. in diese hineingehoben. Vorteilhaft kann die Hub-Dreh-Vorrichtung diesen Bewegungsablauf auch in Gegenrichtung durchführen. Vorteilhaft ist die Hub-Dreh-Vorrichtung somit dazu geeignet, ein Behältnis aus der Behandlungsstation zu heben bzw. aus dieser abzusenken und zur Fördereinrichtung zu schwenken. Vorteilhaft kann die Hubbewegung mithilfe eines Linearmotors ausgeführt werden.

Bei einer vorteilhaften Ausführungsform ist das Verschlusselement starr am Trägerelement angeordnet. Vorteilhaft ist das Verschlusselement in einer Längsrichtung eines Behältnisses unbeweglich am Trägerelement angeordnet. Vorteilhaft wird durch eine feste Anordnung des Verschlusselements am Trägerelement sichergestellt dass eine Bewegung des Trägerelements zu einer gleichen Bewegung des Verschlusselements führt. Insbesondere wird dadurch sichergestellt, dass bei einer Auf- oder Abbewegung des Trägerelements das Verschlusselement über die gleiche Distanz auf- bzw. hinabbewegt wird. Auf diese Weise kann eine Bewegung des Trägerelements in Richtung der Behandlungsstation dazu führen, dass das gleichsam mitbewegte Verschlusselement dichtend an die Behandlungsstation angelegt wird.

Bei einer bevorzugten Ausführungsform weist die Vorrichtung mindestens ein Dichtelement auf. Vorteilhaft ist dieses Dichtelement zwischen der Behandlungsstation und dem Verschlusselement angeordnet. Bevorzugt weist jede Behandlungsstation bzw. jedes Verschlusselement wenigstens ein Dichtelement auf. Vorteilhaft können die Dichtelemente beliebige Profile aufweisen und weisen an ihren Dichtflächen ein elastisches Material auf. Bei dem elastischen Material kann es sich insbesondere um Gummi, Silikon oder dergleichen handeln.

Bei einer bevorzugten Ausführungsform ist die Vakuumvorrichtung dazu geeignet, einen Unterdruck von weniger als 100 mbar in der Behandlungsstation zu erzeugen, bevorzugt von weniger als 10 mbar und besonders bevorzugt von weniger als 1 mbar. Besonders bevorzugt wird ein Druckbereich von 0,1 - 1 mbar durch die Vakuumvorrichtung eingestellt.

Bei einer bevorzugten Ausführungsform ist die Behandlungseinrichtung unbeweglich in der Behandlungsstation angeordnet. Vorteilhaft bewegt sich bei der Einführbewegung der Behandlungseinrichtung in das Behältnis nur das Behältnis, während die Behandlungseinrichtung vorteilhaft ruht.

Vorteilhaft handelt es sich bei der Behandlungseinrichtung um ein längliches, stabförmiges Element, insbesondere eine Lanze. Bevorzugt weist die Behandlungseinrichtung Öffnungen auf. Durch diese Öffnungen kann bevorzugt ein fließfähiges Medium in die Behältnisse eingeleitet werden. Bevorzugt handelt es sich bei diesem fließfähigen Medium um ein für den Plasmaprozess geeignetes Gas. Vorteilhaft kann es sich bei diesem Gas um ein Gemisch aus einem siliziumhaltigen Präkursor und Sauerstoff handeln, insbesondere für eine PECVD (=plasma enhanced chemical vapor deposition) mit Siliziumoxid. Es sind jedoch auch andere Gase denkbar, zum Beispiel Acetylen für die Abscheidung von sog. DLC-Schichten. Für eine Plasmasterilisation können z. B. Argon und Wasserdampf in die Behälter eingeleitet werden.

Vorteilhaft wird dieses Gas homogen im Inneren der Flasche verteilt.

Vorteilhaft dient die Behandlungseinrichtung als Elektrode für die Plasmaerzeugung. Die Energie, die das Plasma zünden soll, kann dann in Form von Hochfrequenz über diese Behandlungseinrichtung in das System eingekoppelt werden.

Bevorzugt weist die Behandlungsstation eine zweite Elektrode auf. Diese Elektrode kann sich vorteilhaft außerhalb des Behältnisses, vorteilhaft jedoch auch innerhalb des Behältnisses befinden. Diese zweite Elektrode kann vorteilhaft geerdet sein oder vorteilhaft floatend mit der ersten Elektrode verbunden.

Bei einer alternativen bevorzugten Ausführungsform kann darauf verzichtet werden, dass die Behandlungseinrichtung als Elektrode für die Plasmaerzeugung dient. Vorteilhaft weist eine solche Ausführungsform eine Vorrichtung zur Erzeugung eines elektromagnetischen Feldes auf. Vorteilhaft ist die Vorrichtung dazu geeignet, ein elektromagnetisches Feld zu erzeugen, das dazu geeignet ist, im eingeleiteten Gas ein Plasma zu zünden. Bei diesem erzeugten elektromagnetischen Feld kann es sich beispielsweise um ein hochfrequentes Feld, jedoch auch z. B. um eine Mikrowelle handeln. Vorteilhaft befindet sich diese Vorrichtung außerhalb des Behältnisses. Bevorzugt wird das elektromagnetische Feld somit von außerhalb des Behältnisses in das Behältnis eingestrahlt.

Bei einer vorteilhaften Ausführungsform weist die Behandlungsstation ein Ventil auf, mit dem die Behandlungsstation, insbesondere nach Beendigung des Plasmaprozesses, belüftet werden kann.

Die vorliegende Erfindung ist weiterhin auf ein Verfahren zum Behandeln von Behältnissen gerichtet, bei dem eine Transporteinrichtung die Behältnisse transportiert und bei dem eine Handhabungsvorrichtung in einem Übergabebereich eine vordefinierte Anzahl von Behältnissen von der Transporteinrichtung übernimmt, auf einem Transportpfad bewegt und in einem Abgabebereich an die Transporteinrichtung oder eine weitere Transporteinrichtung abgibt, wobei wenigstens eine weitere Handhabungsvorrichtung in einem weiteren Übergabebereich eine vordefinierte Anzahl von Behältnissen von der Transporteinrichtung übernimmt, auf einem Transportpfad bewegt und in einem weiteren Abgabebereich an die Transporteinrichtung oder eine weitere Transporteinrichtung abgibt, wobei die Handhabungsvorrichtungen, die Behältnisse auf dem Transportpfad jeweils zu wenigstens einer der Handhabungsvorrichtung zugeordneten Behandlungsstation transportiert.

Erfindungsgemäß wird die Transportgeschwindigkeit der Handhabungsvorrichtungen derart gesteuert, dass die Transportgeschwindigkeit der Handhabungsvorrichtungen bei Übergabe und/oder Abgabe der Behältnisse mit der Transportgeschwindigkeit der Transporteinrichtung und/oder der weiteren Transporteinrichtung synchronisiert ist und die Transportgeschwindigkeit der Handhabungsvorrichtung nach der Übergabe der Behältnisse reduziert wird.

Dabei ist die oben beschriebene Vorrichtung insbesondere dazu eingerichtet und dafür vorgesehen, dieses beschriebene Verfahren durchzuführen, d. h., dass alle für die obig beschriebene Vorrichtung ausgeführten Merkmale ebenso für das hier beschriebene Verfahren offenbart sind und umgekehrt.

Ein bevorzugter Ablauf sieht beispielsweise folgendermaßen aus: Die Handhabungsvorrichtung befindet sich zu Beginn in einer Ruheposition. Sobald sich die von ihr zu behandelnden Behältnisse auf der Transporteinrichtung nähern, startet die Bewegung der Handhabungsvorrichtung. Vorteilhaft handelt es sich dabei um eine Rotationsbewegung. Die Handhabungsvorrichtung nimmt eine definierte Anzahl von Behältnissen von der Transporteinrichtung und beendet die Rotation bei den Behandlungsstationen. Vorteilhaft werden die Behältnisse exakt so weit bewegt, dass jedes Behältnis einer Behandlungsstation zugeordnet ist. Unter dem Begriff "zugeordnet" ist dabei zu verstehen, dass sich das Behältnis in unmittelbarer räumlicher Nähe zu einer Behandlungsstation befindet, also beispielsweise direkt darüber, darunter oder daneben. Vorteilhaft führt die Handhabungsvorrichtung die Behältnisse in die Behandlungsstationen ein und/oder die Behandlungsstationen übernehmen die Behältnisse von der Handhabungsvorrichtung.

Nach Fertigstellung der Behandlung kann eine Bewegung erfolgen, um die Behältnisse aus der Behandlungsstation zu bringen. Eine solche Bewegung muss jedoch nicht zwingend notwendig sein. Beispielsweise ist eine solche Bewegung bei einem Füllventil nicht erforderlich, wenn das Behältnis nur unter eine Auslauföffnung gehalten werden muss. Danach startet die Drehbewegung, um die behandelten Behältnisse an die Transporteinrichtung abzugeben und neue unbehandelte Behälter von der Transporteinrichtung aufzunehmen. Der Zyklus beginnt nun von neuem.

Für ein Funktionieren dieses Systems ist es sehr wichtig, die Taktreihenfolge der Handhabungsvorrichtungen passend festzulegen. Ansonsten kann es passieren, dass eine Handhabungsvorrichtung ein fertig behandeltes Behältnis an den Auslauf übergeben möchte, dies aber nicht möglich ist, da der passende Platz bereits durch ein anderes Behältnis, das zuvor abgegeben wurde, belegt ist. Hiermit ist ein Zeitverlust und somit eine Reduzierung der Maschinenleistung verbunden.

Um das zu vermeiden, muss ein geeignetes Muster gewählt werden, nach dem die Handhabungsvorrichtungen geschaltet werden. Die vorteilhafte Anforderung an ein geeignetes Muster lautet: Sämtliche Behältnisse müssen am Ende der Zulaufstrecke - also spätestens bei der letzten Handhabungsvorrichtung - von der Transporteinrichtung entnommen sein.

Die Schaltreihenfolge der einzelnen Handhabungsvorrichtungen wird bevorzugt so gewählt, dass diese möglichst gleichmäßig verteilt im Einsatz sind. Idealerweise liegt zwischen den Taktungen immer der gleiche zeitliche Abstand.

Bei einem bevorzugten Verfahren werden die Behältnisse auf der Transporteinrichtung und/oder einer weiteren Transporteinrichtung mit konstanter Geschwindigkeit bewegt. Vorteilhaft läuft ein kontinuierlich laufender Behältnisstrom in die Vorrichtung herein und aus ihr heraus, während nur die Behandlung getaktet/stationär stattfindet. Dies hat den Vorteil, dass zwar eine getaktete Behandlung von Behältnissen ermöglicht wird, dabei jedoch dennoch eine problemlose Integration in eine (kontinuierlich laufende) Produktionslinie möglich ist.

Vorteilhaft werden die Behältnisse an die Handhabungsvorrichtungen aus dem vorzugweise mit konstanter Geschwindigkeit laufenden Zulauf übergeben bzw. in den vorzugsweise mit konstanter Geschwindigkeit laufenden Ablauf abgegeben.

Es ist jedoch auch denkbar, dass die Geschwindigkeit der Transporteinrichtung variiert, z. B. um Lücken im Behältnisstrom auszugleichen oder die Behältnisse in ein bestimmtes Teilungsmuster zu bringen. Ein eventuelles Teilungsmuster kann bevorzugt entweder bereits vor der Vorrichtung, in einem Einlaufstern oder in der Transporteinrichtung erzeugt werden.

Vorzugsweise ist die Transportgeschwindigkeit jedoch ab dem ersten Übergabebereich konstant, also ab dem Übergabebereich, der sich am weitesten stromaufwärts befindet, da ab hier die Handhabungsvorrichtungen mit der Behältnisentnahme beginnen. Es ist jedoch auch denkbar, dass die Geschwindigkeit auch auf dieser Strecke variiert wird. Insbesondere können Beschleunigungsphasen zur Zeitersparnis eingefügt werden. Vorteilhaft befinden sich diese Beschleunigungsphasen so zwischen den Übergabebereichen, dass die Behältnisse im Übergabebereich keinen Beschleunigungen ausgesetzt sind. Bevorzugt ist die Geschwindigkeit der Behältnisse in jedem der Übergabebereiche identisch.

Bei einem vorteilhaften Verfahren wird die Geschwindigkeit der Handhabungsvorrichtungen bis zum Stillstand verringert. Vorteilhaft behandeln die Behandlungsstationen die Behältnisse bei Stillstand. Bevorzugt wird die Bewegung, insbesondere eine Rotation, der Handhabungsvorrichtung gestoppt, wenn das Behältnis oder die Behältnisse aus dem Behälterstrom der Transporteinrichtung (Zulauf) entnommen und aus dem Kollisionsbereich mit den nachfolgenden Behältern gebracht worden sind. Unter dem Begriff des Kollisionsbereichs ist dabei der Bereich zu verstehen, bei dem nachfolgende Behältnisse, die von der Transporteinrichtung weitertransportiert werden, mit Behältnissen, die sich in der Handhabungsvorrichtung befinden, zumindest in Berührung kommen können.

In besonderen Fällen kann es auch sinnvoll sein die (Rotations-)Bewegung der Handhabungsvorrichtung nicht komplett bis zum Stillstand zu verzögern, sondern stattdessen mit einer reduzierten Geschwindigkeit an der Behandlungsstation vorbeizufahren.

Nach Beendigung des Behandlungsvorganges wird die Handhabungsvorrichtung erneut in Bewegung gesetzt und mit dem Auslaufteil der Transporteinrichtung synchronisiert. Hierbei kann es sich entweder um den Auslaufteil der ursprünglichen oder einer weiteren Transporteinrichtung handeln. Am Abgabepunkt werden das Behältnis bzw. die Behältnisse anschließend an die Transporteinrichtung abgegeben. Über die Transporteinrichtung verlassen die behandelten Behältnisse die Vorrichtung.

Bei einem vorteilhaften Verfahren transportiert nicht jede Transporteinheit der Transporteinrichtung ein Behältnis. Bevorzugt ist auf der Transporteinrichtung nur jede n-te Transporteinheit bestückt. Besonders bevorzugt handelt es sich dabei um jede zweite Transporteinheit. Somit befindet sich zwischen jeder bestückten Transporteinheit eine (oder möglicherweise auch mehrere) leere Transporteinheiten. Bei den Transporteinheiten kann es sich insbesondere um Neckhandlingklammern handeln.

Dadurch, dass nur jede n-te Transporteinheit bestückt ist, erhöht sich zum einen die Bahngeschwindigkeit, was einen schnelleren Transfer ermöglicht und zum anderen eine Behälterübergabe und -abgabe in nur einem Punkt gestattet.

Dadurch ergibt sich, wenn in der Transporteinrichtung beispielsweise nur jede zweite Klammer bestückt ist, bei gleicher Maschinenleistung eine doppelte Bahngeschwindigkeit. Deshalb kann die Aufnahme und Abgabe der Behälter durch die Handhabungsvorrichtungen schneller erfolgen. Da die Rotationsgeschwindigkeit erhöht wird, sinkt deshalb die Zeit, die für eine Rotation benötigt wird. Auf diese Weise ist eine höhere Maschinenleistung möglich.

Bevorzugt wird dieses Verfahren bei einer Ausführungsform durchgeführt, bei der der Abgabebereich einer Handhabungsvorrichtung mit dem Übergabebereich einer Handhabungsvorrichtung räumlich übereinstimmt.

Vorteilhaft handelt es sich bei den Transporteinheiten, die vor einer Übergabe der Behältnisse an die Handhabungsvorrichtungen die Behältnisse transportieren um Transporteinheiten, die von den Transporteinheiten verschieden sind, die nach einer Abgabe der Behältnisse von den Handhabungsvorrichtungen die Behältnisse transportieren.

An den Übergabe- bzw. Abgabepunkten zwischen den Handhabungsvorrichtungen und der Transporteinrichtung wird bei der Behältnisübergabe somit immer abwechselnd ein Behältnis aufgenommen und abgegeben. Deshalb muss jede Handhabungsvorrichtung nur einmal rotieren, um ihre behandelten Behältnisse abzugeben und neue Behälter aufzunehmen.

Alternativ wäre es unter Inkaufnahme einer längeren Transportzeit auch denkbar, dass jede Handhabungsvorrichtung eine Drehung vollzieht, währenddessen sie die behandelten Behälter abgibt und anschließend eine weitere Drehung, um die neuen Behälter aufzunehmen. Allerdings wird dadurch der Wirkungsgrad der Handhabungsvorrichtung verringert, da die Transportzeit im Vergleich zur Behandlungszeit verlängert wird.

Durch die Bestückung nur jeder n-ten Transporteinheit und die gleichzeitige Übergabe und Abgabe von Behältnissen im Übergabepunkt zu den Handhabungsvorrichtungen müssen die Handhabungsvorrichtungen bevorzugt mehr Handhabungseinheiten wie Behandlungsstationen aufweisen. Vorteilhaft weisen die Handhabungsvorrichtungen n-mal so viele Handhabungseinheiten wie Behandlungsstationen auf, bevorzugt doppelt so viele.

Bevorzugt werden die Behältnisse bei jedem Zyklus abwechselnd von anderen Handhabungseinheiten einer Handhabungsvorrichtung übernommen. Würde man die Handhabungseinheiten einer Handhabungsvorrichtung durchnummerieren, würden beispielsweisen bei einem ersten Zyklus die geradzahligen Handhabungseinheiten mit Behältnissen bestückt, bei einem zweiten Zyklus dagegen die ungeradzahligen Handhabungseinheiten, bei einem dritten Zyklus erneut die geradzahligen Handhabungseinheiten, etc.

Da die Behandlungsstationen jedoch ortsfest in der Vorrichtung platziert sind, kann die Handhabungsvorrichtung bevorzugt mehrere, bevorzugt zwei, Ruhepositionen einnehmen. Bevorzugt werden die Ruhepositionen mit den Zyklen wechselnd angefahren. Vorteilhaft kommt die Drehbewegung der Handhabungsvorrichtungen bei jedem Zyklus so zum Stillstand, dass sich die Behältnisse in unmittelbarer räumlicher Nähe zu den Behandlungsstationen befinden. In dem konkreten Anwendungsfall, bei der jede zweite Transporteinheit und jede zweite Handhabungseinheit besetzt wird, haben die Handhabungsvorrichtungen zwei Stellungen die abwechselnd mit jedem Zyklus angefahren werden, um die Behältnisse in die Behandlungsstationen einbringen zu können.

Hierbei hat bevorzugt eine der Handhabungsvorrichtungen eine Handhabungseinheit weniger als die restlichen Handhabungsvorrichtungen. Dies ist vorteilhaft, damit sich auch im Auslauf der Transporteinrichtung ein kontinuierlicher Behältnisstrom mit wechselnder vollleer-Bestückung ergibt. Vorteilhaft werden die behandelten Behältnisse von den Handhabungsvorrichtungen bei jedem Zyklus abwechselnd vor und nach den unbehandelten Behältnissen in die Transporteinrichtung eingesetzt. Um diesen Wechsel vorteilhaft auszugleichen ist eine Handhabungsvorrichtung mit einer verringerten Handhabungseinheit erforderlich.

Bei einem vorteilhaften Verfahren werden die Behältnisse nach Abschluss des Behandlungsvorgangs umgehend von der dieser Behandlungsstation zugeordneten Handhabungsvorrichtung zum Abgabebereich transportiert. Bevorzugt sind die Schaltungen der Handhabungsvorrichtungen und die Transporteinrichtung so aufeinander abgestimmt, dass jede Handhabungsvorrichtung nach Abschluss des Behandlungsvorganges umgehend ihre behandelten Behälter an die Transporteinrichtung abgeben und neue Behältnisse aufnehmen kann, so dass keine unnötigen Wartezeiten entstehen.

Vorteilhaft werden die Behältnisse nach Fertigstellung der Behandlung ohne Zeitverzögerung wieder an die Transporteinrichtung übergeben, so dass am Auslauf der Vorrichtung ein lückenloser Behältnisstrom aus der Vorrichtung läuft. Vorteilhaft weist der Behältnisstrom lediglich dann im Auslauf der Vorrichtung Lücken auf, wenn bereits der Einlauf lückenhaft ist. Auch wenn bereits der Einlauf lückenhaft ist, ist es jedoch denkbar, dass diese Lücken im Behältnisstrom in gewissem Maße ausgeglichen werden. Hierfür kommt beispielsweise der Einsatz eines Langstatorlinearmotors als Transporteinrichtung in Betracht.

Es wäre auch möglich, eine Ausschleusung von "Schlechtbehältern" zu integrieren. Bevorzugt werden im Falle von auszuschleusenden Behältnissen diese nicht von einer Handhabungsvorrichtung übernommen, sondern bis ans Ende der Zulaufstrecke transportiert. An dieser Stelle können die Behältnisse dann ausgeschleust werden.

Bei einem bevorzugten Verfahren werden die Behältnisse der Vorrichtung in der gleichen Reihenfolge zugeführt, in der sie diese verlassen.

Bevorzugt kann der Abstand zwischen den einzelnen Behältnissen und/oder zwischen Batchs, bestehend aus mehreren Behältnissen, verändert werden. Vorteilhaft kann bei einer niedrigen Leistung der Abstand zwischen den Batchs vergrößert werden.

Bei einem vorteilhaften Verfahren kann die Handhabungsvorrichtung zusätzlich zur Transportbewegung eine Hubbewegung der Behältnisse durchführen. Bevorzugt beinhaltet eine Handhabungsvorrichtung einen Stern/ein Karussell, das eine Dreh- und Hubbewegung durchführen kann. Beide Bewegungen finden in getakteter Art und Weise statt.

Eine solche Hubbewegung ist beispielsweise bei einer Behälterbeschichtungsmaschine oder einer Sterilisationsvorrichtung vorteilhaft. Bei einer Behälterbeschichtungsmaschine werden bevorzugt leere (Kunststoff-)Behältnisse auf der Innenseite mit einer Beschichtung versehen um die Gasdurchlässigkeit zu verringern.

Vorteilhaft wird ein Behältnis durch eine Hubbewegung in eine Vakuumkammer der Behandlungsstation eingetaucht, in der der Beschichtungsvorgang ausgeführt wird.

Ein bevorzugtes Verfahren sieht im Fall einer Behältnisinnenbeschichtung folgendermaßen aus: Wenn der oder die Behältnisse aus dem Behältnisstrom (Zulauf) entnommen und aus dem Kollisionsbereich mit den nachfolgenden Behältnissen gebracht worden sind, wird die Rotation der Handhabungsvorrichtung gestoppt. Anschließend wird eine Hubbewegung (wahlweise ein Heben oder Senken, je nachdem, ob sich die Behandlungsstation unter oder über der Handhabungsvorrichtung befindet) durchgeführt, um die zu beschichtenden Behältnisse in die Behandlungskammer einzugeben. Nun wird der Beschichtungsvorgang durchgeführt. Anschließend werden die beschichteten Behältnisse wieder aus der Kammer gehoben bzw. aus dieser abgesenkt. Dabei ist auch denkbar, dass die Hub- oder Senkbewegung nicht an die Rotationsbewegung anschließend, sondern mit dieser leicht überlagert beginnt.

Bei einer Behältnisinnenbeschichtung entnimmt die Handhabungsvorrichtung bevorzugt die unbehandelten Behältnisse aus der Transporteinrichtung und bringt diese in eine oder mehrere Vakuumkammern ein, in der der eigentliche Beschichtungsprozess geschieht, da dieser unter bestimmten Umgebungsbedingungen, beispielsweise im Vakuum, erfolgen muss. Vorteilhaft wird die Vakuumkammer nach Einbringen des Behältnisses evakuiert. Eine beispielhafte Abfolge der Prozessschritte könnte folgendermaßen aussehen:
0,5 Sekunden: Einbringen des Behältnisses in die Kammer (z. B. durch Absenken) 2 Sekunden: Evakuieren der Kammer
5 Sekunden: Beschichtungsvorgang
1 Sekunde: Belüften
1,5 Sekunden: Ausfahren des Behältnisses aus der Kammer und Abgabe des beschichteten Behältnisses und Bestücken der Station mit neuen Behältnissen.

Die Dauer eines Zyklus liegt in diesem Beispiel bei ca. 10 Sekunden. Man kann leicht erkennen, dass die Vakuumpumpe nur in 20 % der Zeit benötigt wird (2 von 10 Sekunden). Die restliche Zeit ist diese untätig.

Dies kann vorteilhaft vermieden werden, indem sich mehrere Handhabungsvorrichtungen eine Vakuumpumpe teilen. Dies erfordert jedoch eine entsprechend günstige Takt-Abfolge der Handhabungsvorrichtungen. So wäre es zum Beispiel schlecht, wenn Handhabungsvorrichtung a zum Zeitpunkt 0 s mit dem Zyklus beginnt und Handhabungsvorrichtung b, die sich mit der Handhabungsvorrichtung a eine Vakuumpumpe teilt, zum Zeitpunkt 1 s. Denn zum Zeitpunkt 1 s ist die Handhabungsvorrichtung a noch nicht vollkommen evakuiert. Wird nun bei 1 s Handhabungsvorrichtung b auf die Vakuumpumpe aufgeschaltet, wird das Vakuum in Handhabungsvorrichtung a wieder verschlechtert, d. h. der Druck steigt. Auf diese Weise kann keine prozesssichere Evakuierung erfolgen.

Deshalb wird die Schaltreihenfolge der Handhabungsvorrichtungen vorteilhaft so gewählt, dass die Stationen nicht gleichzeitig/überlappend das Vakuum benötigen, sondern in einem geeigneten zeitlichen Abstand. Die Schaltreihenfolge und die Schaltzeitpunkte sollen also bevorzugt so gewählt werden, dass die Vakuumpumpe(n) möglichst gleichmäßig ausgelastet sind.

Eine möglichst gleichmäßige Auslastung der Vakuumpumpe(n) wird vorteilhaft über eine entsprechende Wahl der geometrischen Verhältnisse und Schaltreihenfolge der Handhabungsvorrichtungen in Abhängigkeit von der Maschinenleistung (Behälterdurchsatz pro Stunde), der Behälterteilung (Abstand der Behälter auf der Transporteinrichtung), der Anzahl der Handhabungsvorrichtungen in der Maschine und der Anzahl der unterschiedlichen Takte erreicht.

Unabhängig von dem beschriebenen Verfahren ist die Erfindung außerdem auf ein Verfahren zum Beschichten von Behältnissen gerichtet, bei dem das Behältnis mithilfe einer Fördereinrichtung entlang eines Transportpfads P transportiert wird, mithilfe eines Trägerelements in einer von Null verschiedenen Richtung zum Transportpfad P in eine Behandlungsstation eingeführt wird und in das Behältnis eine Behandlungseinrichtung eingeführt wird, wobei die Behandlungsstation in einem nächsten Schritt evakuiert wird und das Behältnis mit einem Plasma beschichtet wird.

Erfindungsgemäß wird ein am Trägerelement angeordnetes Verschlusselement auf die Behandlungsstation zubewegt und das Verschlusselement verschließt die Behandlungsstation im Wesentlichen luftdicht.

Es wird darauf hingewiesen, dass dieses Verfahren auch unabhängig von dem oben beschriebenen Verfahren Anwendung finden kann. Die Anmelderin behält sich daher vor, auch für dieses Verfahren Schutz zu beanspruchen.

Dabei ist die oben beschriebene Vorrichtung zum Beschichten von Behältnissen insbesondere dazu eingerichtet und dafür vorgesehen, dieses beschriebene Verfahren durchzuführen, d. h., dass alle für die obig beschriebene Vorrichtung zum Behandeln von Behältnissen ausgeführten Merkmale ebenso für das hier beschriebene Verfahren offenbart sind und umgekehrt.

Vorteilhaft wird das Verschlusselement aufgrund der Bewegung des Trägerelements auf die Behandlungsstation zubewegt.

Vorteilhaft wird das Behältnis insbesondere auf einer Innenseite mit Plasma beschichtet. Vorteilhaft wird dazu über eine Behandlungseinrichtung in das Innere des Behältnisses ein Gas eingebracht. Bevorzugt wird ein für den Plasmaprozess geeignetes Gas in die Flasche eingeleitet und möglichst homogen im Inneren der Flasche verteilt. Bevorzugt wird das in das Innere des Behältnisses eingebrachte Gas gezündet, so dass ein Plasma entsteht. Hierzu kann beispielsweise eine Elektrode in das Behältnis eingebracht werden. Die Energie, die das Plasma zünden soll, kann dann in Form von Hochfrequenz über diese Elektrode in das System eingekoppelt werden.

Während der Behälter der Plasmabehandlung unterzogen wird, wird vorteilhaft permanent das entstehende Abgas abgepumpt. Vorteilhaft wird die Behandlungsstation nach Beendigung des Plasmaprozesses über ein Ventil belüftet.

Bei einem bevorzugten Verfahren wird das Behältnis nach dem Ende des Beschichtungsvorgangs mithilfe des Trägerelements aus der Behandlungsstation ausgeführt. Vorteilhaft wird das Behältnis zur Behandlung in die Behandlungsstation mithilfe des Trägerelements abgesenkt und nach der Behandlung aus der Behandlungsstation gehoben.

Bei einem vorteilhaften Verfahren werden zwei Vakuumpumpen für die Evakuierung verwendet. Vorteilhaft evakuiert die erste Pumpe die Vakuumkammer auf ein erstes Druckniveau. Die zweite Vakuumpumpe evakuiert die Vakuumkammer bevorzugt auf ein zweites Druckniveau, das unterhalb des ersten Druckniveaus liegt. Vorteilhaft entspricht das zweite Druckniveau dem Druckniveau, bei dem der eigentliche Beschichtungsprozess stattfindet. Auf diese Weise wird die erforderliche Evakuierungszeit vorteilhaft nacheinander auf zwei Pumpen aufgeteilt. Bei dem dargestellten Beispiel evakuiert jede Pumpe bevorzugt also nur noch ca. 1 Sekunde.

Weitere Vorteile und Ausführungsformen ergeben sich aus den beigefügten Zeichnungen:
Darin zeigen:
- Fig. 1: eine schematische Darstellung eines Ausführungsbeispiels einer erfindungsgemäßen Vorrichtung;
- Fig. 2: eine vergrößerte Darstellung des Übergabebereichs;
- Fig. 3: eine schematische Darstellung eines alternativen Ausführungsbeispiels einer erfindungsgemäßen Vorrichtung;
- Fig. 4: eine schematische Darstellung eines Ausführungsbeispiels einer erfindungsgemäßen Vorrichtung während der Durchführung des erfindungsgemäßen Verfahrens;
- Fig. 5: eine schematische Darstellung eines Ausführungsbeispiels einer erfindungsgemäßen Vorrichtung mit Reservestation;
- Fig. 6: eine schematische Darstellung eines alternativen Ausführungsbeispiels einer erfindungsgemäßen Vorrichtung, bei der der Übergabe- und Abgabebereich räumlich übereinstimmen;
- Fig. 7: eine schematische Darstellung eines Ausführungsbeispiels einer erfindungsgemäßen Vorrichtung mit einer linearen Transporteinrichtung;
- Fig. 8: eine schematische Darstellung eines Ausführungsbeispiels einer erfindungsgemäßen Vorrichtung mit einem Transportkarussell;
- Fig. 9: eine schematische Darstellung eines Ausführungsbeispiels einer erfindungsgemäßen Vorrichtung mit Sternsäulen;
- Fig. 10a: eine schematische Darstellung eines Ausführungsbeispiels einer erfindungsgemäßen Vorrichtung, bei der jede zweite Transporteinheit besetzt ist;
- Fig. 10b: eine schematische Darstellung eines Ausführungsbeispiels einer erfindungsgemäßen Vorrichtung, bei der jede zweite Transporteinheit besetzt ist, während eines zweiten Zyklus;
- Fig. 11: eine vergrößerte Darstellung des Übergabebereichs von einem Einlaufstern zu einer Transporteinrichtung;
- Fig. 12: eine schematische Darstellung eines Ausführungsbeispiels einer erfindungsgemäßen Vorrichtung mit einem separaten Ein- und Auslaufstern;
- Fig. 13a: eine Darstellung eines Ausführungsbeispiels einer erfindungsgemäßen Vorrichtung mit beispielhaften Größenangaben;
- Fig. 13b: Tabelle mit einer günstigen Schaltreihenfolge für das in Fig. 13a gezeigte Beispiel;
- Fig. 14a: eine weitere Darstellung eines Ausführungsbeispiels einer erfindungsgemäßen Vorrichtung mit beispielhaften Größenangaben;
- Fig. 14b: Tabelle mit einer günstigen Schaltreihenfolge für das in Fig. 14a gezeigte Beispiel;
- Fig. 15a: eine weitere Darstellung eines Ausführungsbeispiels einer erfindungsgemäßen Vorrichtung mit beispielhaften Größenangaben;
- Fig. 15b: Tabelle mit einer günstigen Schaltreihenfolge für das in Fig. 15a gezeigte Beispiel;
- Fig. 16: Darstellung einer Behandlungskammer zum Beschichten von Behältnissen.

Für gleiche oder gleich wirkende Elemente der Erfindung werden jeweils identische Bezugszeichen verwendet. Ferner werden der Übersicht halber nur Bezugsziffern in den einzelnen Figuren verwendet, die für die Beschreibung der jeweiligen Figur erforderlich sind. Die zeichnerisch dargestellten Ausführungsformen stellen lediglich Beispiele dar, wie die erfindungsgemäße Vorrichtung und das erfindungsgemäße Verfahren ausgestaltet sein können und stellen keine abschließende Begrenzung der Erfindung bzw. der erfinderischen Gedanken dar.

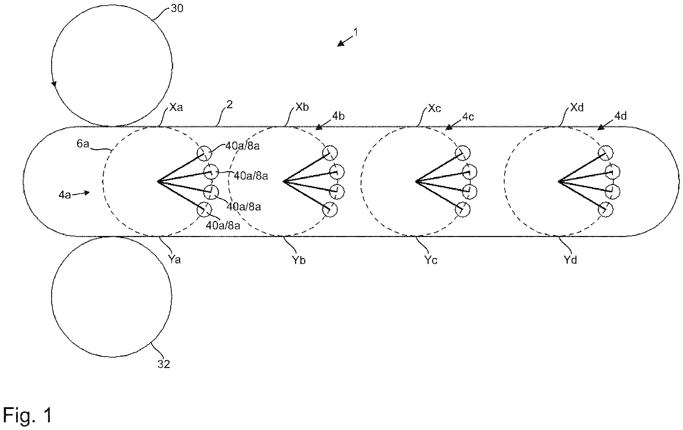

Fig. 1 zeigt eine schematische Darstellung eines Ausführungsbeispiels einer erfindungsgemäßen Vorrichtung 1. Darin ist eine Transporteinrichtung 2 zu erkennen, die Behältnisse 10 (nicht gezeigt) transportieren kann. Die Behältnisse werden vom Einlaufstern 30 an die Transporteinrichtung 2 abgegeben. Die Vorrichtung 1 weist mehrere Handhabungsvorrichtungen 4 auf. Die Handhabungsvorrichtungen sind zur besseren Unterscheidbarkeit mit den zusätzlichen Bezugszeichen a-d versehen. Somit bezieht sich das Bezugszeichen 4a auf die Handhabungsvorrichtung, die dem Einlaufstern am nächsten ist, sich also am weitesten stromaufwärts befindet. 4b kennzeichnet die darauffolgende Handhabungsvorrichtung, 4c die dritte Handhabungsvorrichtung und 4d die vierte und letzte Handhabungsvorrichtung. Während das Bezugszeichen 4 mit Buchstabenzusatz somit eine konkrete Handhabungsvorrichtung bezeichnet, bezieht sich das Bezugszeichen 4 allgemein auf die Handhabungsvorrichtungen, ohne dass zwischen den konkreten Handhabungsvorrichtungen differenziert wird. Gleiches gilt für weitere Bezugszeichen, die teilweise mit, teilweise ohne Buchstabenzusatz verwendet werden.

Jede Handhabungsvorrichtung weist einen drehbaren Träger 6 auf. Aus Gründen der Übersichtlichkeit wurde nur der Träger der Handhabungsvorrichtung 4a mit dem Bezugszeichen 6a versehen. Jede Handhabungsvorrichtung 4 weist außerdem mehrere, in diesem Fall vier, Handhabungseinheiten 40 auf, von denen jede dazu geeignet ist, ein Behältnis 10 aufzunehmen. Auch hier wurden aus Gründen der Übersichtlichkeit nur die Handhabungseinheiten 40a der Handhabungsvorrichtung 4a mit einem Bezugszeichen versehen.

In Fig. 1 befinden sich die Handhabungsvorrichtungen 4 in einer Position, in der sich die Handhabungseinheiten 40 jeweils in unmittelbarer Nähe (beispielsweise über) den ortsfesten Behandlungsstationen 8 der jeweiligen Handhabungsvorrichtungen befinden. So weist beispielsweise die Handhabungsvorrichtung 4a vier Behandlungsstationen 8a auf, die sich unmittelbar unter den Handhabungseinheiten 40a befinden und nicht separat gezeigt sind.

Jede Handhabungsvorrichtung 4 weist außerdem einen Übergabebereich X und einen Abgabebereich Y auf. Im Übergabebereich X können Behältnisse 10 von der Transporteinheit 2 an die Handhabungsvorrichtungen 4 übergeben werden. Im Abgabebereich Y können Behältnisse 10 von den Handhabungsvorrichtungen an die Transporteinrichtung 2 abgegeben werden.

Bei einem erfindungsgemäßen Verfahren werden somit der Handhabungsvorrichtung 4a im Übergabebereich Xa bevorzugt vier Behältnisse 10 übergeben. Diesen Behältnissen 10 nachfolgende Behältnisse werden von der Transporteinrichtung 2 - bevorzugt mit kontinuierlicher Geschwindigkeit-weitertransportiert. Auch an die Handhabungsvorrichtungen 4b, 4c und 4d werden jeweils in den Übergabebereichen Xb, Xc und Xd Behältnisse übergeben. Dabei ist es zwar möglich, nicht jedoch zwingend, dass die Behältnisse an die Handhabungsvorrichtungen in aufsteigender Reihenfolge übergeben werden. Es ist auch denkbar, dass beispielsweise zuerst Behältnisse an die Handhabungsvorrichtung 4b übergeben werden, anschließend an 4d, anschließend an 4c und erst zum Schluss an 4a. Es ist auch möglich, dass mehreren Handhabungsvorrichtungen 4 gleichzeitig Behältnisse übergeben werden. Vorteilhaft ist die Taktreihenfolge jedoch immer gleich, d. h. die Reihenfolge, in der den Handhabungsvorrichtungen Behältnisse übergeben werden, bleibt bevorzugt gleich. Um eine Behandlung aller Behältnisse sicherzustellen, muss die Taktreihenfolge so gewählt werden, dass die Behältnisse spätestens an die letzte Handhabungsvorrichtung (hier 4d) übergeben werden. Demnach soll die Transporteinrichtung 2 bei der Krümmung auf der rechten Seite der Fig. 1 bevorzugt keine Behältnisse enthalten.

Nachdem die Behältnisse 10 einer Handhabungsvorrichtung 4 übergeben wurden, werden diese mithilfe des im Uhrzeigersinn drehbaren Trägers 6 zu den Behandlungsstationen 8 transportiert und dort behandelt. Nach der Behandlung werden die Behältnisse 10 von der Handhabungsvorrichtung 4 zum Abgabepunkt Y weitertransportiert und dort an die Transporteinrichtung 2 abgegeben. Vorteilhaft dauert die Behandlung in den Behandlungsstationen 8a-d jeweils gleich lang. Demnach werden die Behältnisse 10, die zu einem früheren Zeitpunkt an eine Handhabungsvorrichtung 4 übergeben wurden, auch zu einem früheren Zeitpunkt abgegeben, als die Behältnisse, die zu einem späteren Zeitpunkt übergeben wurden.

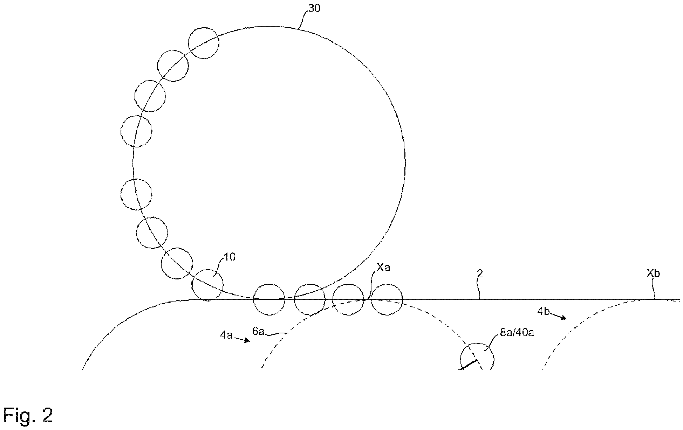

Fig. 2 zeigt einen vergrößerten Ausschnitt des Einlaufsterns 30 und der Übergabebereiche Xa und Xb. Zu erkennen ist außerdem ein Ausschnitt der Transporteinrichtung 2. Vom Einlaufstern 30 werden Behältnisse 10 an die Transporteinrichtung 2 übergeben. Die Behältnisse 10 sind jeweils zu Gruppen (Batch) von vier Behältnissen 10 zusammengefasst. Bei dieser beispielhaften Ausführungsform weist der Behältnisstrom nach vier Behältnissen eine Lücke auf. Am unteren Figurenrand sind teilweise die Handhabungsvorrichtungen 4a und 4b zu erkennen. Bei den Handhabungsvorrichtungen 4a und 4b ist auch jeweils der Übergabebereich Xa bzw. Xb zu erkennen. Der erste Behältnis-Batch wird in Fig. 2 gerade über den Übergabebereich Xa hinwegbewegt. Diese Behältnisse werden nicht von der Handhabungsvorrichtung 4a übernommen, sondern von der Transporteinrichtung 2 weitertransportiert. Diese Behältnisse werden stattdessen (nicht gezeigt) zu einem späteren Zeitpunkt an eine der folgenden Handhabungsvorrichtungen übergeben. Im unteren Bereich der Fig. 2 ist auch eine Handhabungseinheit 40a an der Position einer Behandlungsstation 8a zu erkennen.

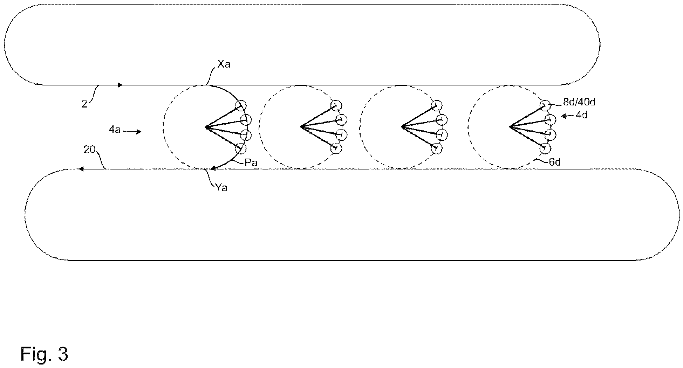

Fig. 3 zeigt eine schematische Darstellung einer alternativen erfindungsgemäßen Vorrichtung. Diese alternative Vorrichtung weist im Gegensatz zu der bei Fig. 1 und Fig. 2 gezeigten Vorrichtung 2 Transporteinrichtungen 2 bzw. 20 auf. Die Transporteinrichtungen 2 bzw. 20 sind als Transportoval ausgestaltet und parallel zueinander angeordnet. Die Handhabungsvorrichtungen 4 sind zwischen den Transporteinrichtungen 2 und 20 angeordnet. Die unbehandelten Behältnisse (nicht gezeigt) werden auf der Transporteinrichtung 2 von links nach rechts (gegen den Uhrzeigersinn) bewegt. Wie bei Fig. 1 beschrieben, werden die Behältnisse (auch bei diesem Beispiel in Gruppen zu je vier Behältnissen) an die Handhabungsvorrichtungen 4 übergeben. Behältnisse, die von einer bestimmten Handhabungsvorrichtung 4a-c nicht übernommen werden, werden mit der Transporteinrichtung 2 an dieser Handhabungsvorrichtung vorbeitransportiert. Um eine Behandlung aller Behältnisse sicherzustellen, muss die Taktreihenfolge so gewählt werden, dass die Behältnisse spätestens an die letzte Handhabungsvorrichtung (hier 4d) übergeben wird. Es sollen somit keine Behältnisse an der Handhabungsvorrichtung 4d vorbei über die Krümmung der Transporteinrichtung 2 auf der rechten Seite wieder zurück auf die linke Seite transportiert werden. (Ausnahme: Es wäre denkbar an dieser Stelle eine Ausleitung für "Schlechtbehälter" zu integrieren. Behälter die den Qualitätsanforderungen nicht genügen würden in diesem Fall von keiner Handhabungsvorrichtung von der Transporteinrichtung 2 übernommen, sondern würden auf der Transporteinrichtung 2 weitertransportiert und an einem geeigneten Ort (z. B. im von rechts nach links laufenden oberen Teil des Transfersystems) aus der Transporteinrichtung 2 ausgeschleust.).

Auch bei dem in Fig. 3 gezeigten Beispiel drehen sich die Handhabungsvorrichtungen 4 im Uhrzeigersinn auf dem Transportpfad P. Aus Gründen der Übersichtlichkeit wurden nur bei der Handhabungsvorrichtung 4a der Transportpfad Pa, der Übergabebereich Xa und der Abgabebereich Ya mit einem Bezugszeichen versehen. Jede Handhabungsvorrichtung 4 weist wieder einen beweglichen Träger 6, mehrere Handhabungseinheiten 40 und Behandlungsstationen 8 auf. Auch bei Fig. 3 befinden sich alle Handhabungsvorrichtungen in einer Ruheposition, bei der die Handhabungseinheiten 40 bei den (nicht näher gezeigten) Behandlungsstationen 8 platziert sind. Aus Gründen der Übersichtlichkeit wurden auch hier nicht alle Bezugszeichen eingezeichnet.

Nach der Behandlung werden die Behältnisse 10 an den Abgabepunkten Y an eine weitere Transporteinrichtung 20 abgegeben. Diese bewegt sich bevorzugt ebenfalls gegen den Uhrzeigersinn. Die an den oberen parallelen Bereich der Transporteinrichtung 20 abgegebenen Behältnisse werden somit von rechts nach links transportiert.

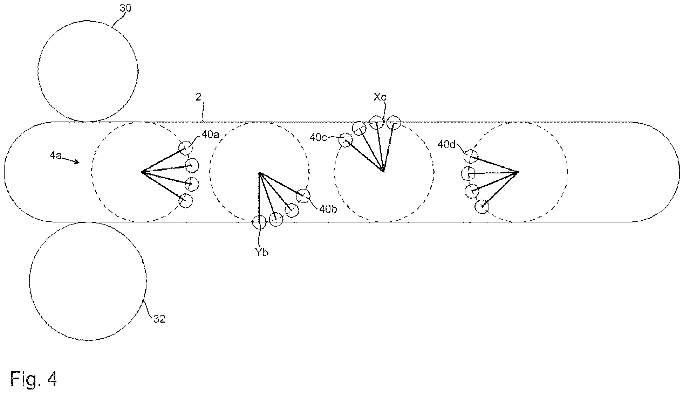

Fig. 4 zeigt ein Ausführungsbeispiel einer erfindungsgemäßen Vorrichtung während der Durchführung eines erfindungsgemäßen Verfahrens. Die Vorrichtung entspricht im Wesentlichen der Vorrichtung, wie sie bereits in Fig. 1 beschrieben wurde. Im Unterschied zu Fig. 1 ist jedoch zu erkennen, dass sich nicht mehr alle Handhabungsvorrichtungen 4 in der Ruheposition bei den Behandlungsstationen 8 befinden.

Bei der Handhabungsvorrichtung 4a befinden sich die Handhabungseinheiten 40a unmittelbar bei den Behandlungsstationen 8a. Die der Handhabungsvorrichtung 4a zugeordneten Behältnisse 10 (von den Handhabungseinheiten 40a transportiert, jedoch nicht separat gezeigt) werden zu dem in Fig. 4 gezeigten Zeitpunkt von den Behandlungsstationen 8 behandelt. Vorteilhaft ist die Geschwindigkeit der Handhabungsvorrichtung 4a zu diesem Zeitpunkt vollständig abgebremst.

Bei der Handhabungsvorrichtung 4b befindet sich dagegen die erste Handhabungseinheit 40b am Abgabepunkt Yb. Die Handhabungsvorrichtung 4b gibt somit gerade die bereits behandelten Behältnisse 10 an die Transporteinrichtung 2 ab. Vorteilhaft ist die Geschwindigkeit der Handhabungsvorrichtung 4b zu diesem Zeitpunkt mit der Geschwindigkeit der Transporteinrichtung 2 synchronisiert. In dem von Fig. 4 gezeigten Zeitpunkt wird von der ersten Handhabungseinheit 40b ein Behältnis in eine freie Transporteinheit 22 abgegeben. Die Handhabungseinrichtung 4b und die Transporteinrichtung 2 bewegen sich bevorzugt in einer solchen Geschwindigkeit, dass das nächste behandelte Behältnis in der zweiten Handhabungseinheit 40b an die nächste freie Transporteinheit 22 abgegeben werden kann.

Die Handhabungsvorrichtung 4d dreht sich zu dem in Fig. 4 gezeigten Zeitpunkt weiter im Uhrzeigersinn. Die Handhabungsvorrichtung 4d hat zu diesem Zeitpunkt bereits alle behandelten Behältnisse abgegeben, so dass die Handhabungseinheiten 40d leer sind und keine Behältnisse führen. Die Geschwindigkeit der Handhabungsvorrichtung 4d kann an dieser Stelle verhältnismäßig beliebig gewählt werden. So ist es beispielsweise möglich, dass die Geschwindigkeit gleichbleibend ist, die Geschwindigkeit von Handhabungsvorrichtung 4d und Transporteinrichtung 2 in diesem Bereich synchronisiert bleiben. Dies vereinfacht die erforderliche Steuerung. Es ist jedoch auch denkbar, dass die Handhabungsvorrichtung 4d in diesem Bereich beschleunigt wird. Dies kann beispielsweise aus Gründen der Zeitersparnis sinnvoll sein. Es ist auch denkbar, dass die Geschwindigkeit in diesem Bereich reduziert wird, beispielsweise um eine gewünschte Taktreihenfolge einhalten zu können.

Bei der Handhabungsvorrichtung 4c befinden sich die Handhabungseinheiten 40c dagegen im Übergabebereich Xc. Die erste Handhabungseinheit 40c hat sich bereits am Übergabebereich Xc vorbei bewegt und ein unbehandeltes Behältnis aufgenommen. Die zweite Handhabungseinheit 40c befindet sich unmittelbar vor dem Übergabebereich Xc und steht kurz vor der Aufnahme eines unbehandelten Behältnisses. Bevorzugt sind die Geschwindigkeiten der Transporteinrichtung 2 und der Handhabungsvorrichtung 4c zu diesem Zeitpunkt synchronisiert. Bevorzugt wird jeweils das Behältnis in der nächsten Transporteinheit 22 an die nächste Handhabungseinheit 40c übergeben.

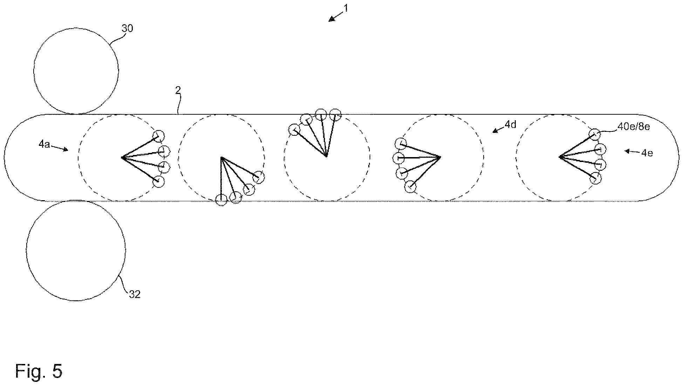

Fig. 5 zeigt ein Ausführungsbeispiel einer erfindungsgemäßen Vorrichtung mit einer Reservestation. Die Figur entspricht im Wesentlichen der Darstellung in Fig. 4. Auch in Fig. 5 befinden sich die Handhabungsvorrichtungen 4a-4d in ähnlichen Positionen wie in Fig. 4. Zusätzlich weist die Vorrichtung 1 in Fig. 5 jedoch noch eine Reservestation auf. Diese Reservestation besteht insbesondere aus einer Handhabungsvorrichtung 4e mit Handhabungseinheiten 40e. Der Handhabungsvorrichtung 4e sind außerdem Behandlungsstationen 8e zugeordnet, die sich ortsfest unterhalb der Handhabungseinheiten 40e befinden und in Fig. 5 nicht separat gezeigt sind. In diesem Ausführungsbeispiel werden der Handhabungsvorrichtung 4e nur dann Behältnisse übergeben, wenn eine der Handhabungsvorrichtungen 4a-d nicht benutzt werden kann, beispielsweise weil ein Defekt vorliegt oder eine Wartung erforderlich ist.

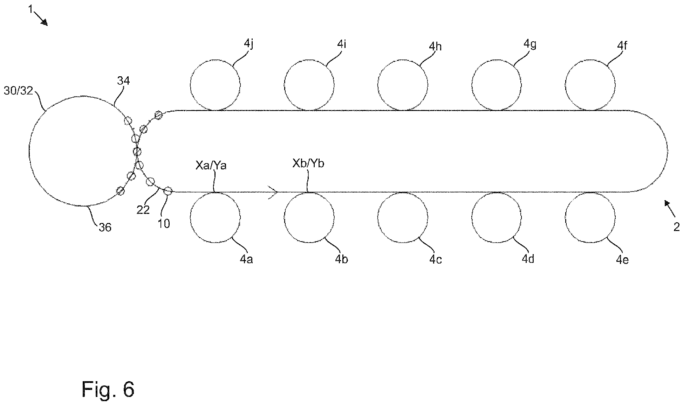

Fig. 6 zeigt ein Ausführungsbeispiel, bei dem der Übergabe- und Abgabebereich räumlich übereinstimmen. Hier weist die Vorrichtung 1 einen Einlaufstern 30 auf, der gleichzeitig die Rolle als Auslaufstern 32 übernehmen kann. Der Stern dreht sich bei diesem Beispiel im Uhrzeigersinn. Unbehandelte Behältnisse 10 werden über den Zulauf 34 (oberer Bereich des Sterns) der Transporteinrichtung 2 zugeführt. Sowohl auf dem Ein- bzw. Auslaufstern als auch auf der Transporteinrichtung 2 ist nur jede zweite Transporteinheit 22 besetzt. Leere Transporteinheiten 22 sind im Übergabebereich symbolisch mit einem kleinen Strich gekennzeichnet, während besetzte Transporteinheiten mit einem Kreis gekennzeichnet sind. Dieses Besetzungsmuster setzt sich fort, wobei die Kennzeichnung aus Gründen der Übersichtlichkeit nicht fortgesetzt ist.

Die Behältnisse 10 werden von der Transporteinrichtung 2 gegen den Uhrzeigersinn transportiert. An den Übergabebereichen X können Behältnisse an Handhabungsvorrichtungen 4 übergeben werden. Die Handhabungsvorrichtungen 4 sind in diesem Fall außen um die Transporteinrichtung 2 herum angeordnet. Behältnisse, die nicht von der Handhabungsvorrichtung 4a übernommen werden, werden von der Transporteinrichtung 2 weitertransportiert, etc. Behältnisse, die an eine Handhabungsvorrichtung 4 übergeben wurden, werden von der Handhabungsvorrichtung 4 zu stationären Behandlungsstationen 8 (nicht gezeigt) transportiert. Nachdem die Behältnisse behandelt wurden, werden sie von der Handhabungsvorrichtung 4 zum Abgabebereich Y (übereinstimmend mit dem Übergabebereich X) weitertransportiert. Im Abgabebereich Y werden die (nun behandelten) Behältnisse 10 erneut an die Transporteinrichtung 2 abgegeben. Die behandelten Behältnisse 10 (schraffiert gezeichnet) verlassen die Transporteinrichtung 2 und werden an den Auslaufstern 30/32 (Auslauf 36) übergeben.

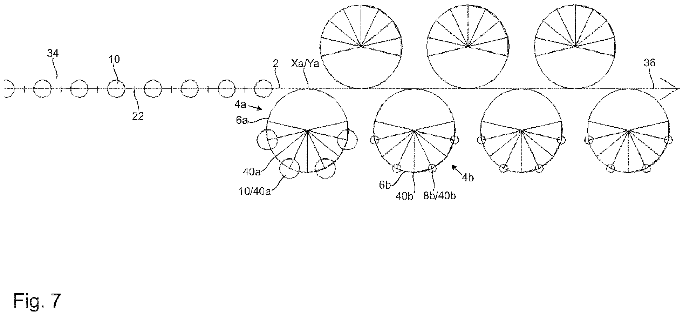

Fig. 7 zeigt eine alternative Anordnung. Hier ist die Transporteinheit 2 nicht oval, sondern linear ausgestaltet. Auf der linken Seite der Figur befindet sich der Zulauf 34, auf der rechten Seite der Auslauf 36. Auch hier ist nur jede zweite Transporteinheit 22 mit einem Behältnis 10 bestückt. Die Handhabungsvorrichtungen 4 sind seitlich an der linearen Transporteinheit 2 angeordnet.

Beispielhaft ist gezeigt, dass die Handhabungsvorrichtung 4a einen drehbaren Träger 6a aufweist und der Übergabebereich Xa mit dem Abgabebereich Ya übereinstimmt. Die Handhabungsvorrichtung 4a weist mehrere Handhabungseinheiten 40a (radiale Linien) auf. Jede zweite Handhabungseinheit 40a ist mit einem Behältnis 10 (großer Kreis) bestückt. Die anderen Handhabungseinheiten 40a sind in Fig. 7 leer. Bei der ebenfalls noch beispielhaft beschilderten Handhabungsvorrichtung 4b sind ebenfalls mehrere Handhabungseinheiten 40b vorhanden. Hier sind alle Handhabungseinheiten 40b unbesetzt gezeigt. Erkennbar sind jedoch die (beispielsweise unterhalb befindlichen) Behandlungsstationen 8b (durch einen kleinen Kreis gekennzeichnet). Hierbei ist erkennbar, dass die stationären Stationen lediglich unterhalb jeder zweiten Handhabungseinheit 40b angeordnet sind. Die Position der in der Handhabungsvorrichtung 4a befindlichen Behältnisse 10 stimmt mit der Position der Behandlungsstationen überein. D. h. die Handhabungsvorrichtungen 4 drehen sich nach der Aufnahme von Behältnissen 4 exakt so weit, dass die Behältnisse 10 von den zugeordneten Behandlungsstationen übernommen werden können.

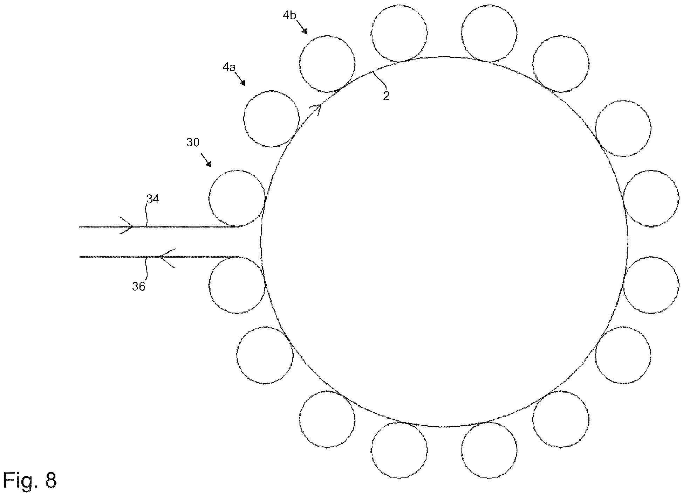

In Fig. 8 ist die Transporteinrichtung 2 als Transportkarussell ausgestaltet. Die Handhabungsvorrichtungen 4 sind wie Satelliten um die Transporteinrichtung 2 herum angeordnet. Die Behältnisse werden über einen Zulauf 34 und einen Einlaufstern 30 der Transporteinrichtung zugeführt und über einen Auslaufstern 32 und einen Auslauf 36 abgeführt. Die Transporteinrichtung dreht sich bei diesem Ausführungsbeispiel im Uhrzeigersinn.

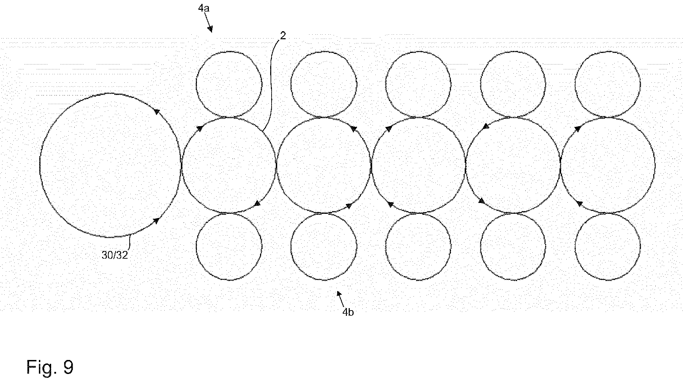

Fig. 9 zeigt eine alternative Ausführungsform. Hier ist die Transporteinrichtung 2 in Form von Sternsäulen ausgestaltet. Die Behältnisse können wieder über einen sowohl als Einlauf- als auch Auslaufstern 30/32 der Transporteinrichtung 2 zugeführt werden. Die Behältnisse werden von einem ersten Transferstern, der sich im Uhrzeigersinn dreht, übernommen, an einen zweiten Transferstern, der sich gegen den Uhrzeigersinn dreht weitergegeben, etc. Die Behältnisse legen auf diese Weise einen mäanderförmigen Weg zurück. Seitlich zu der Reihe von Transfersternen sind die Handhabungsvorrichtungen 4 angeordnet.

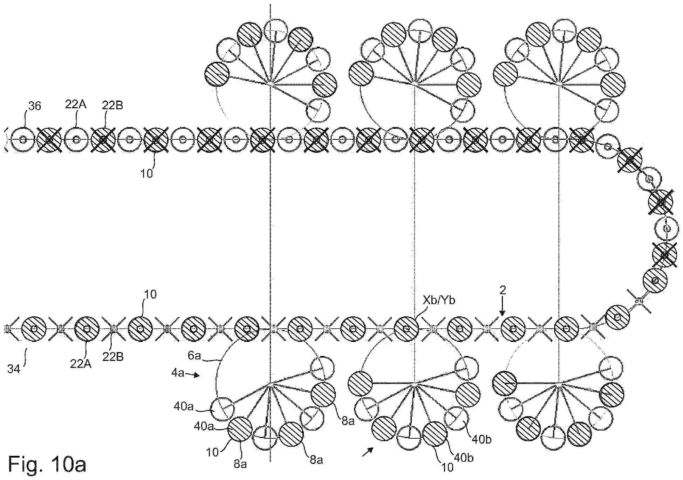

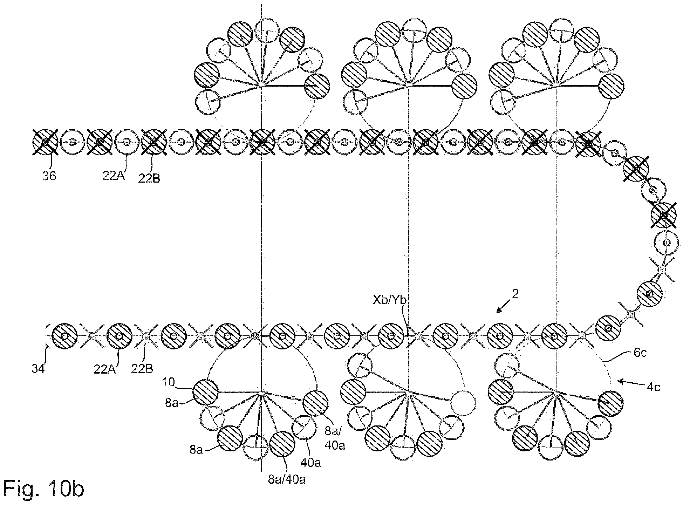

Fig. 10a und Fig. 10b zeigen dieselbe Ausführungsform einer erfindungsgemäßen Vorrichtung zu zwei unterschiedlichen Zeitpunkten. In beiden Figuren ist zu sehen, dass die Transporteinrichtung 2 eine Vielzahl von Transporteinheiten 22 aufweist. Zur Unterscheidung sind die Transporteinheiten abwechselnd mit einem Kreis (22A) oder einem Kreuz (22B) gekennzeichnet. Schraffierte Kreise kennzeichnen ein Behältnis 10.

Um die Transporteinrichtung 2 angeordnet sind mehrere Handhabungsvorrichtungen 4. Beispielhaft ist eingezeichnet, dass die Handhabungsvorrichtung 4a einen Träger 6a und mehrere Handhabungseinheiten 40a (Kreise an radialen Linien) aufweist. Diese Handhabungseinheiten 40a sind abwechselnd mit einem Behältnis 10 besetzt (schraffierter Kreis) bzw. unbesetzt (ungefüllter Kreis). Unterhalb der mit einem Behältnis 10 besetzten Handhabungsvorrichtungen 40a befinden sich die Behandlungsstationen 8a (nicht separat gezeigt).

Auch bei der Handhabungsvorrichtung 4b ist beispielhaft eingezeichnet, dass diese aus mehreren Handhabungseinheiten 40b besteht, von denen jede zweite mit einem Behältnis 10 besetzt ist. Der Übergabebereich Xb und der Abgabebereich Yb stimmen überein.

Während eines erfindungsgemäßen Verfahrens dreht sich beispielsweise die Handhabungsvorrichtung 4b von dieser Position aus im Uhrzeigersinn. Am Abgabepunkt Yb gibt sie zunächst ein behandeltes Behältnis 10 aus der ersten Handhabungseinheit 40b an eine unbesetzte Transporteinheit ab. Nachdem sich sowohl die Handhabungsvorrichtung 4b als auch die Transporteinrichtung 2 synchronisiert weiterbewegt haben, übergibt die Transporteinrichtung 2 aus der hierauf folgenden, besetzten Transporteinheit 22 ein unbehandeltes Behältnis 10 an die zweite (unbesetzte) Handhabungseinheit 40b ab. Die Transporteinrichtung 2 und die Handhabungsvorrichtung 4b drehen sich erneut synchronisiert weiter. Die Handhabungsvorrichtung 4b gibt das nächste behandelte Behältnis aus der dritten Handhabungseinheit 40b an die nächste, unbesetzte Transporteinheit 22 ab, etc. Wie zu erkennen ist, sind deshalb am Zulauf 34 die Transporteinheiten 22A (mit Kreis markiert) mit einem Behältnis besetzt, während am Auslauf 36 die Transporteinheiten 22B (mit Kreuz markiert) mit einem Behältnis besetzt sind. Es ist somit erkennbar, dass die behandelten Behältnisse von den Transporteinheiten 22B transportiert werden, während die unbehandelten Behältnisse von den Transporteinheiten 22A transportiert werden.

Nachdem alle Handhabungseinheiten 40b die behandelten Behältnisse abgegeben haben, bzw. neue unbehandelte Behältnisse aufgenommen haben, dreht sich die Handhabungsvorrichtung 4b bis zu der Position weiter, in der die mit Behältnisse bestückten Handhabungseinheiten 40b über den Behandlungsstationen 8b positioniert sind, damit die Behältnisse 10 in diesen behandelt werden können. Wie ein Vergleich der Figuren 10a und 10b zeigt, nehmen die Handhabungsvorrichtungen 4 daher zwei unterschiedliche Ruhepositionen ein. So ist beispielsweise die Handhabungsvorrichtung 4b in Fig. 10b um eine Drehposition weitergedreht: In Fig. 10a ist die letzte Handhabungseinheit 40b mit einem Behältnis besetzt und befindet sich in der "9-Uhr-Position" unmittelbar über einer Behandlungsstation 8b. In Fig. 10b ist dagegen die letzte Handhabungseinheit 40b unbesetzt und die vorletzte Handhabungseinheit 40b besetzt. Damit sich auch hier das Behältnis unmittelbar über der Behandlungsstation 8b befindet, muss die Handhabungsvorrichtung 4b entsprechend weiter gedreht sein.

Zusätzlich ist eine Besonderheit zu sehen: Eine der Handhabungsvorrichtungen (in diesem Fall Handhabungsvorrichtung 4a) hat eine Handhabungseinheit 40a weniger als die restlichen Handhabungsvorrichtungen 4b-4f. Dies ist erforderlich, damit sich auch im Auslauf der Transporteinrichtung 2 ein kontinuierlicher Behältnisstrom mit wechselnder voll-leer-Bestückung ergibt. Die behandelten Behältnisse werden von den Handhabungsvorrichtungen bei jedem Zyklus abwechselnd vor und nach den unbehandelten Behältnissen in die Transporteinrichtung 2 eingesetzt. Um diesen Wechsel auszugleichen, ist die eine Handhabungsvorrichtung 4a mit verringerter Anzahl an Handhabungseinheiten 40a erforderlich.

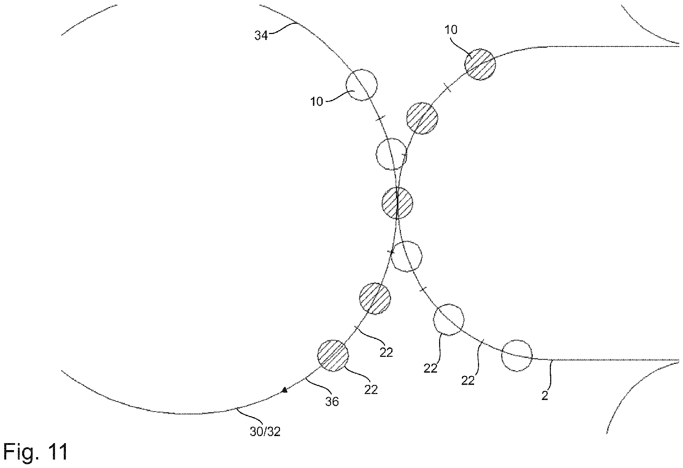

Fig. 11 zeigt in vergrößerter Darstellung den Zulauf vom Einlaufstern 30 zur Transporteinrichtung 2 bzw. den Auslauf von der Transporteinrichtung. Beidseitig des Übergabepunktes ist nur jede zweite Transporteinheit 22 mit einem Behältnis 10 bestückt. Die unbestückten Transporteinheiten 22 sind mit einem Strich gekennzeichnet. Die unbehandelten Behältnisse 10 sind mit einem ungefüllten Kreis dargestellt, die behandelten Behältnisse mit einem Kreis mit schraffierter Füllung. Am Übergabepunkt befindet sich gerade ein behandeltes Behältnis 10, das von der Transporteinrichtung 2 an den Ein- bzw. Auslaufstern 30/32 übergeben wird. Drehen sich der Ein- bzw. Auslaufstern 30/32 und die Transporteinrichtung 2 weiter, treffen als nächstes eine unbesetzte Transporteinheit 22 der Transporteinrichtung 2 und ein unbehandeltes Behältnis (derzeit beide oberhalb des Übergabepunktes) aufeinander. Der Ein- bzw. Auslaufstern 30/32 kann somit ein unbehandeltes Behältnis an eine unbesetzte Transporteinheit 22 abgeben. Bei einem Weiterdrehen treffen als nächstes ein behandeltes Behältnis 10 der Transporteinrichtung 2 und eine unbesetzte Transporteinheit 22 des Ein- bzw. Auslaufsterns 30/32 aufeinander. Die Transporteinrichtung 2 kann somit das behandelte Behältnis an den Ein- bzw. Auslaufstern 30/32 abgeben.

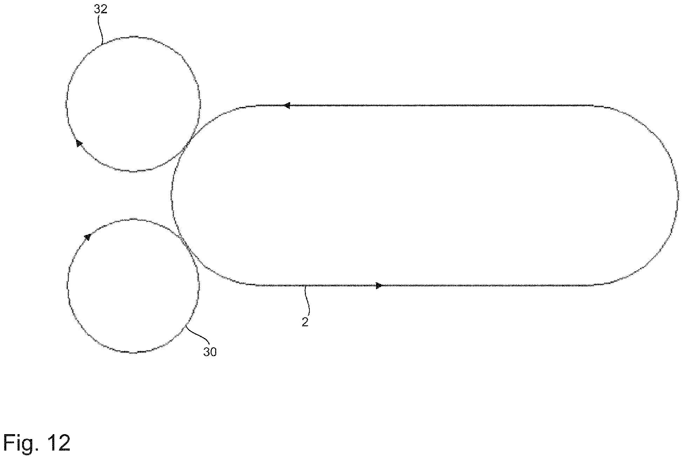

Fig. 12 zeigt eine alternative Ausführungsform, bei der der Einlaufstern 30 und der Auslaufstern 32 als separate Sterne ausgestaltet sind.

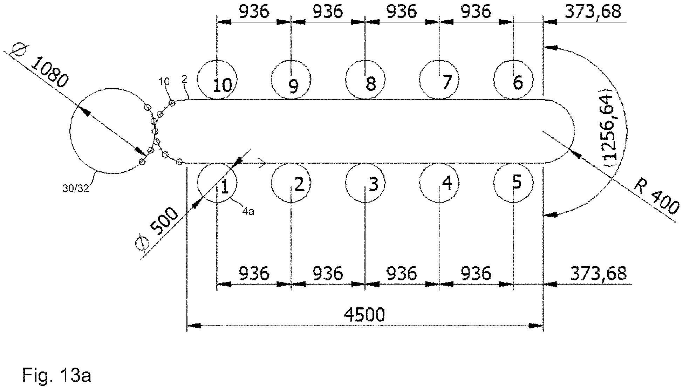

Fig. 13a zeigt eine bevorzugte Ausführungsform mit beispielhaften Maßangaben, wie sie insbesondere bei einer Behälterbeschichtungsmaschine vorteilhaft sind. Wichtig sind hier vor allem die Maße 936 mm (Abstand zwischen den Übergabe-/Abgabepunkten X/Y), 373,68 mm (Abstand zwischen dem letzten Übergabe-/Abgabepunkt und dem Beginn der Krümmung des Transferovals) und R400 mm (Radius der Krümmung des Transferovals), also die Abstände der Handhabungsstationen an der Transporteinrichtung 2 entlang. Mit dieser Anordnung und einer Bahngeschwindigkeit der Transporteinrichtung von 0,8 m/s (Teilung der Transporteinheiten auf der der Transporteinrichtung: 120 mm) ergibt sich ein Taktabstand von 1,185 s. Bei 10 Stationen ergibt sich eine Zyklusdauer von 10 x 1,185 s = 11,85 s.

Bei einem beispielhaften Beschichtungsprozess müssen für das Evakuieren der Vakuumkammer ca. 2 Sekunden veranschlagt werden. Da aber bereits nach 1,185 s die nächste Handhabungsvorrichtung schaltet kommen hier zwei Vakuumpumpen für die Evakuierung zum Einsatz. Jede Pumpe evakuiert also nur noch ca. 1 Sekunde. Dies ist weniger als die aus der Taktung zur Verfügung stehenden 1,185 s, also findet wie gewünscht keine zeitliche Überschneidung der Evakuierungsvorgänge statt.

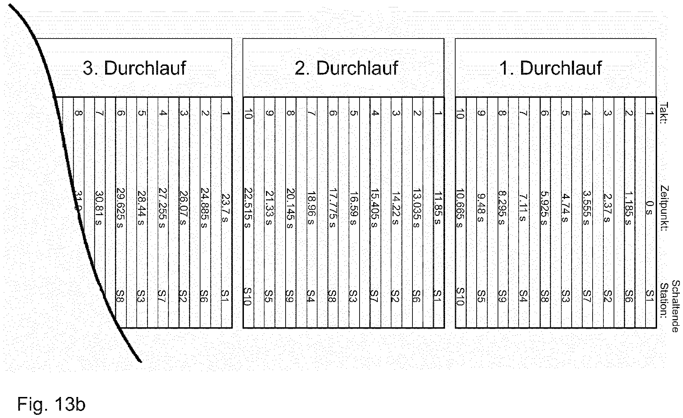

Eine günstige Schaltreihenfolge der 10 Handhabungsvorrichtungen ist in Fig. 13b dargestellt. Hierbei bezieht sich die Abkürzung "S1" auf die Handhabungsvorrichtung 4a, "S2" auf die Handhabungsvorrichtung 4b, etc.

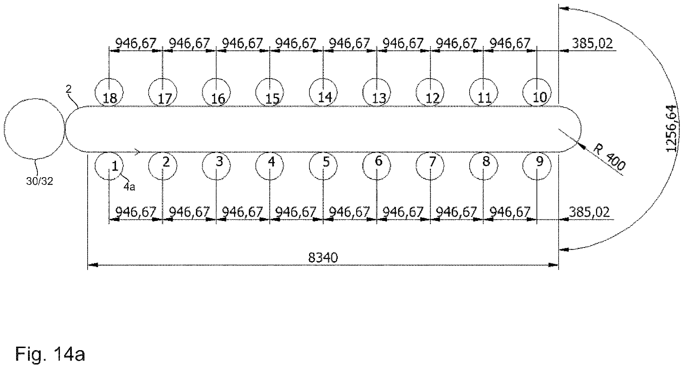

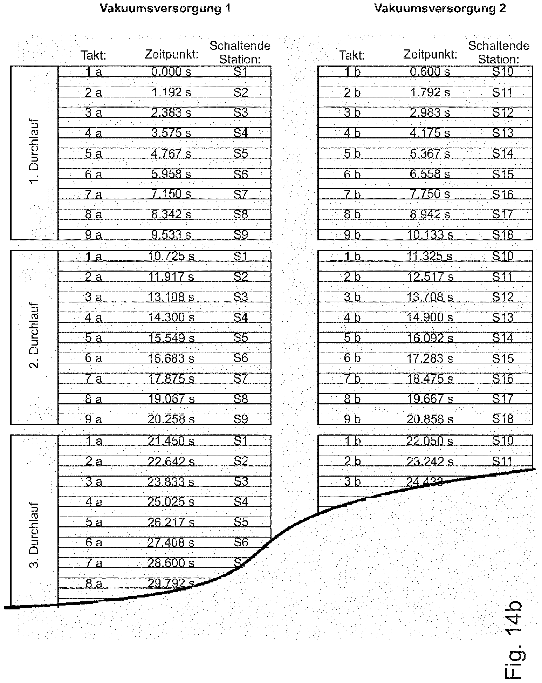

Eine weitere bevorzugte Baugröße ist in Fig. 14a und die zugehörige Schaltreihenfolge in Fig. 14b dargestellt. Eine Besonderheit stellt hier die doppelte Vakuumversorgung dar. Diese ist nötig, da aufgrund der geometrischen Verhältnisse ein gleichzeitiges Takten von zwei Handhabungsvorrichtungen nicht möglich ist. Deshalb takten die Stationen 10-18 um 0,6 s versetzt zu den Stationen 1-9.

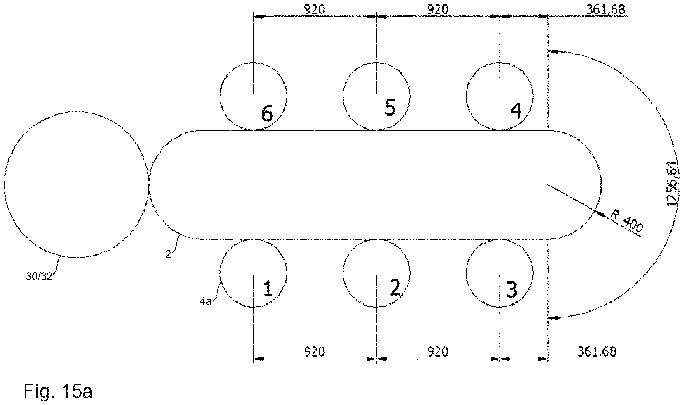

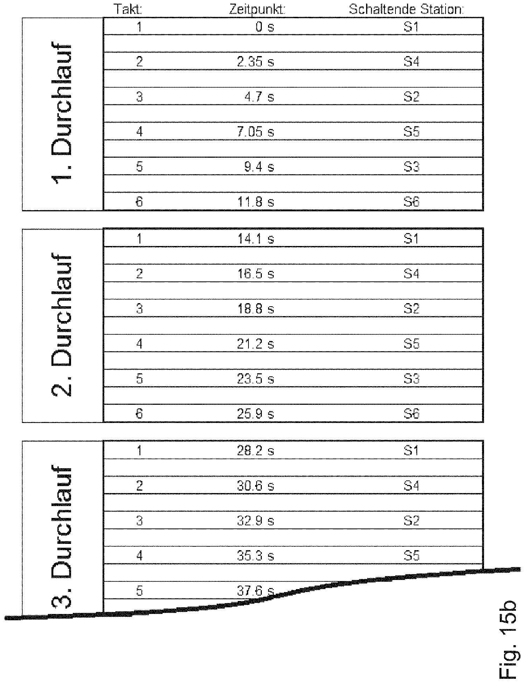

Eine weitere bevorzugte Baugröße ist in Fig. 15a und die zugehörige Schaltreihenfolge in Fig. 15b dargestellt.

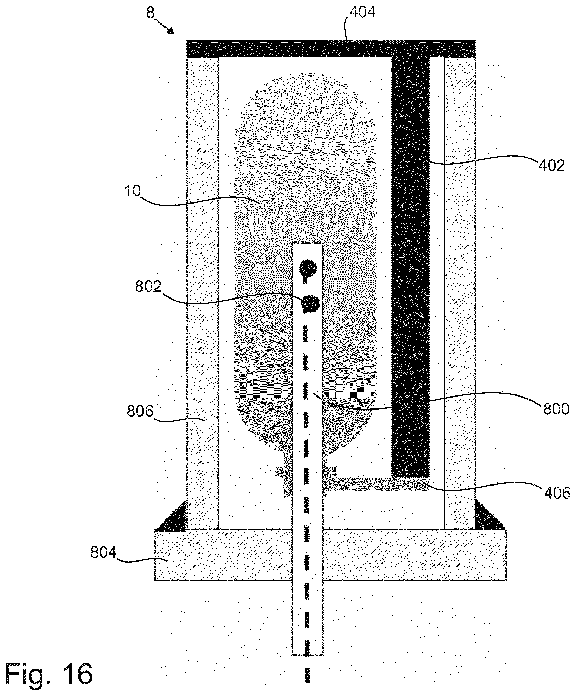

Fig. 16 zeigt eine Darstellung einer Behandlungsstation 8. In die Behandlungsstation 8 ist ein Behältnis 10 eingeführt. Dieses wird von einem Trägerelement 402 mithilfe eines Greifers 406 gehalten. Das Trägerelement 402 kann senkrecht nach oben bewegt werden, so dass das vom Greifer 406 gehaltene Behältnis 10 ebenfalls senkrecht nach oben und aus der Behandlungsstation 8 herausbewegt wird.

Die Behandlungsstation 8 umfasst ein stationäres Bodenteil 804 und stationäre Wandungen 806. Am Trägerelement 402 ist ein Verschlusselement 404 angeordnet. Dieses ist gemeinsam mit dem Trägerelement 402 beweglich. Wird das Trägerelement 402 nach oben bewegt, wird somit auch das Verschlusselement 404 von den Wandungen 806 der Behandlungsstation 8 abgehoben. Befindet sich das Trägerelement 402 dagegen - wie gezeigt - in seiner tiefsten Position, schließt das Verschlusselement 404 gemeinsam mit den Wandungen 806 die Behandlungsstation 8 luftdicht ab.

In der Behandlungsstation 8 befindet sich außerdem eine Behandlungseinrichtung 800. Diese ist vorteilhaft ebenfalls stationär angeordnet, so dass das Behältnis 10 beim Einführen in die Behandlungsstation 8 über die Behandlungseinrichtung 800 geschoben wird. Die Behandlungseinrichtung 800 weist mehrere Öffnungen 802 auf, durch die vorteilhaft Plasma in das Innere des Behältnisses 10 gebracht werden kann.

Die Anmelderin behält sich vor sämtliche in den Anmeldungsunterlagen offenbarten Merkmale als erfindungswesentlich zu beanspruchen, sofern sie einzeln oder in Kombination gegenüber dem Stand der Technik neu sind. Es wird weiterhin darauf hingewiesen, dass in den einzelnen Figuren auch Merkmale beschrieben wurden, welche für sich genommen vorteilhaft sein können. Der Fachmann erkennt unmittelbar, dass ein bestimmtes in einer Figur beschriebenes Merkmal auch ohne die Übernahme weiterer Merkmale aus dieser Figur vorteilhaft sein kann. Ferner erkennt der Fachmann, dass sich auch Vorteile durch eine Kombination mehrerer in einzelnen oder in unterschiedlichen Figuren gezeigter Merkmale ergeben können.

### Bezugszeichenliste

- 1: Vorrichtung
- 2/20: Transporteinrichtung
- 4(a, b, c, ...): Handhabungsvorrichtung
- 6(a, b, c, ...): beweglicher Träger
- 8(a, b, c, ...): Behandlungsstationen
- 10: Behältnis
- 22 (A, B): Transporteinheit
- 30: Einlaufstern
- 32: Auslaufstern
- 34: Zulauf
- 36: Auslauf
- 40(a, b, c, ...): Handhabungseinheit
- 402: Trägerelement
- 404: Verschlusselement
- 406: Greifer
- 800: Behandlungseinrichtung
- 802: Öffnungen
- 804: Bodenteil der Behandlungsstation
- 806: Wandung der Behandlungsstation
- P(a, b, c, ...): Transportpfad
- X(a, b, c, ...): Übergabebereich
- Y(a, b, c, ...): Abgabebereich

## Patentansprüche

1. Vorrichtung (1) zum Beschichten von Behältnissen (10) mit wenigstens einer Vakuumvorrichtung zur Erzeugung eines Vakuums, mit wenigstens einer Behandlungsstation (8) zum Beschichten von Behältnissen (10) mit einem Plasma, wobei die Behandlungsstation (8) in einer Fluidverbindung mit der Vakuumvorrichtung steht und wobei die Behandlungsstation (8) wenigstens eine Behandlungseinrichtung (800) aufweist, die in ein Behältnis (10) einführbar ist, mit einer Fördereinrichtung zum Transportieren von Behältnissen (10) auf einem Transportpfad P und mit wenigstens einem Trägerelement (402) zur Aufnahme von mindestens einem Behältnis (10)
**dadurch gekennzeichnet, dass**
das Trägerelement (402) in einer von Null verschiedenen Richtung zum Transportpfad P der Behältnisse beweglich ist und dazu geeignet ist, das Behältnis (10) in die Behandlungsstation (8) einzuführen, wobei an dem Trägerelement (402) ein Verschlusselement (404) angeordnet ist und das Verschlusselement (404) dazu geeignet ist, die Behandlungsstation (8) im Wesentlichen luftdicht zu verschließen.

2. Vorrichtung nach Anspruch 1,
**dadurch gekennzeichnet, dass**
die Fördereinrichtung dazu geeignet ist, die Behältnisse entlang eines umlaufenden Transportpfades zu bewegen.

3. Vorrichtung nach einem der vorangegangenen Ansprüche,
**dadurch gekennzeichnet, dass**
die Behandlungsstation (8) unter oder über des Transportpfads P der Behältnisse (10) angeordnet ist und/oder die Bewegung des Trägerelements (402) zum Einführen des Behältnisses (10) in die Behandlungsstation (8) nach unten oder oben erfolgt.

4. Vorrichtung nach einem der vorangegangenen Ansprüche,
**dadurch gekennzeichnet, dass**
das Trägerelement (402) dazu ausgebildet ist, die Behältnisse (10) mit ihrer Öffnung nach unten zu transportieren.

5. Vorrichtung nach einem der vorangegangenen Ansprüche,
**dadurch gekennzeichnet, dass**
die Behandlungseinrichtung (800) Öffnungen (802) aufweist, durch die ein fließfähiges Medium in die Behältnisse (10) eingeleitet werden kann.

6. Vorrichtung nach einem der vorangegangenen Ansprüche,
**dadurch gekennzeichnet, dass**
die Behandlungseinrichtung (800) als Elektrode für die Plasmaerzeugung dient.

7. Vorrichtung nach dem vorangegangenen Anspruch,
**dadurch gekennzeichnet, dass**
die Behandlungsstation (8) eine zweite Elektrode aufweist.

8. Verfahren zum Beschichten von Behältnissen (10) wobei das Behältnis (10) mithilfe einer Fördereinrichtung entlang eines Transportpfads P transportiert wird, mithilfe eines Trägerelements (402) in einer von Null verschiedenen Richtung zum Transportpfad P in eine Behandlungsstation (8) eingeführt wird und in das Behältnis (10) eine Behandlungseinrichtung (800) eingeführt wird, wobei die Behandlungsstation (8) in einem nächsten Schritt evakuiert wird und das Behältnis (10) mit einem Plasma beschichtet wird,
**dadurch gekennzeichnet, dass**
ein am Trägerelement (402) angeordnetes Verschlusselement (404) auf die Behandlungsstation (8) zubewegt wird und das Verschlusselement (404) die Behandlungsstation (8) im Wesentlichen luftdicht verschließt.

9. Verfahren nach dem vorangegangenen Anspruch,
**dadurch gekennzeichnet, dass**
das Behältnis (10) nach dem Ende des Beschichtungsvorgangs mithilfe des Trägerelements (402) aus der Behandlungsstation (8) ausgeführt wird.

10. Verfahren nach einem der beiden vorangegangenen Ansprüche,
**dadurch gekennzeichnet, dass**
das Behältnis (10) zur Behandlung in die Behandlungsstation (8) mithilfe des Trägerelements (402) abgesenkt wird und nach der Behandlung aus der Behandlungsstation (8) gehoben wird.
